(19) Europäisches Patentamt / European Patent Office / Office européen des brevets

(11) **EP 4 047 846 B1**

(12) **EUROPEAN PATENT SPECIFICATION**

(45) Date of publication and mention
of the grant of the patent:
**19.02.2025 Bulletin 2025/08**

(21) Application number: **20893271.5**

(22) Date of filing: **27.11.2020**

(51) International Patent Classification (IPC):
$H04L\ 1/00^{(2006.01)}$     $H03M\ 13/11^{(2006.01)}$

(52) Cooperative Patent Classification (CPC):
**H03M 13/116; H03M 13/618; H03M 13/6516;
H04L 1/0057; H04L 1/007;** H03M 13/6306

(86) International application number:
**PCT/CN2020/132388**

(87) International publication number:
**WO 2021/104480 (03.06.2021 Gazette 2021/22)**

(54) **CODING AND DECODING METHODS AND DEVICES**

CODIERUNGS- UND DECODIERUNGSVERFAHREN UND -VORRICHTUNGEN

PROCÉDÉS ET DISPOSITIFS DE CODAGE ET DE DÉCODAGE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **28.11.2019 CN 201911194568**

(43) Date of publication of application:
**24.08.2022 Bulletin 2022/34**

(73) Proprietor: **Huawei Technologies Co., Ltd.
Shenzhen, Guangdong 518129 (CN)**

(72) Inventors:
• **LIN, Wei
Shenzhen, Guangdong 518129 (CN)**
• **LI, Jiahui
Shenzhen, Guangdong 518129 (CN)**
• **MA, Mengyao
Shenzhen, Guangdong 518129 (CN)**
• **YAN, Min
Shenzhen, Guangdong 518129 (CN)**

(74) Representative: **Goddar, Heinz J.
Boehmert & Boehmert
Anwaltspartnerschaft mbB
Pettenkoferstrasse 22
80336 München (DE)**

(56) References cited:
**WO-A1-2018/144560**    **WO-A1-2018/148742**
**CN-A- 108 023 673**    **CN-A- 108 400 836**
**CN-A- 108 631 790**    **CN-A- 108 809 509**

• **QIN WANG (USTB): "LDPC Code Proposal ;
15-10-0242-00-004g-ldpc-code-proposal", IEEE
DRAFT; 15-10-0242-00-004G-LDPC-CODE-
PROPOSAL, IEEE-SA MENTOR, PISCATAWAY,
NJ USA, vol. 802.154g, 15 April 2010
(2010-04-15), pages 1 - 7, XP017665807**
• **HONGJIANG XIAO ET AL: "Joint resources
allocation for cooperative video transmission",
IMAGE PROCESSING (ICIP), 2009 16TH IEEE
INTERNATIONAL CONFERENCE ON, IEEE,
PISCATAWAY, NJ, USA, 7 November 2009
(2009-11-07), pages 921 - 924, XP031628697,
ISBN: 978-1-4244-5653-6**

EP 4 047 846 B1

## Description

This application claims priority to Chinese Patent Application No. 201911194568.0, filed with the China National Intellectual Property Administration on November 28, 2019 and entitled "ENCODING AND DECODING METHOD AND APPARATUS.

## TECHNICAL FIELD

This application relates to the field of communication technologies, and in particular, to an encoding and decoding method and an apparatus.

## BACKGROUND

Multimedia communication is a new communication mode in which a plurality of types of media data (for example, a voice, data, an image, or a video) can be provided during a call. At present, multimedia data coding and transmission technologies have become a hot research focus in the field of multimedia communication. A sending apparatus usually encodes different multimedia data by using a same coding matrix, to obtain an encoded codeword; and then transmits the encoded codeword to a receiving apparatus. However, in practical application, different multimedia data has different priorities. If the foregoing coding scheme is used, when a coding rate is high, transmission reliability of high-priority multimedia data cannot be ensured; and when the coding rate is low, low-priority multimedia data also occupies a large number of transmission resources, resulting in high transmission resource overheads.

QIN WANG (USTB), "LDPC Code Proposal; 15-10-0242-00-004g-ldpc-code-proposal", IEEE DRAFT; 15-10-0242-00-004G-LDPC-CODE-PROPOSAL, IEEE-SA MENTOR, PISCATAWAY, NJ USA, (20100415), vol. 802.154g discloses code rate, code length and parity check matrices. This document discloses a table linking information length to code rate and codeword length.

WO 2018/144560 A1 discloses an apparatus and method. The apparatus includes a transceiver and processor, which attach transport block (TB) level CRC bits to a TB, select an LDPC base graph (BG) based on a code rate (CR) and TB size of the TB including TB level CRC bits, determine a number of code blocks (CBs) to use for segmenting the TB including TB level CRC bits depending on the selected LDPC BG, determine a single CB size for each of the CBs based on the number of CBs, segment the TB including TB level CRC bits into the CBs based on the number of CBs and CB size, pad zeros to a last CB of the CBs in the segmented TB, attach CB level CRC bits to each CB in the segmented TB, encode each CB in the segmented TB using the selected LDPC base graph, and transmit the encoded CBs.

HONGJIANG XIAO ET AL discloses a cooperative multiple-input multiple output (MIMO) architecture to transmit the video reliably.

## SUMMARY

This application provides an encoding and decoding method and an apparatus, to improve data transmission reliability and save transmission resources. The present invention is defined by the appended set of claims.

To achieve the objective, this application provides the following technical solutions.

According to a first aspect, an embodiment of this application provides a sending apparatus. The sending apparatus includes a processing unit and a sending unit. The processing unit is configured to determine a first low-density parity-check LDPC matrix based on a quantity $n_1$ of first transmission bits; the processing unit is further configured to encode information bits based on the first LDPC matrix, to obtain the first transmission bits; and the sending unit is configured to send the first transmission bits; wherein the quantity $n_1$ of the first transmission bits has a correspondence with a coding rate of the first LDPC matrix, including: if $n_1$ is less than N0, the coding rate of the first LDPC matrix is 5/6; if $n_1$ is greater than or equal to NO and less than N1, the coding rate of the first LDPC matrix is 5/6; if $n_1$ is greater than or equal to N1 and less than N2, the coding rate of the first LDPC matrix is 3/4; if $n_1$ is greater than or equal to N2 and less than N3, the coding rate of the first LDPC matrix is 2/3; if $n_1$ is greater than or equal to N3 and less than or equal to N4, the coding rate of the first LDPC matrix is 1/2; or if $n_1$ is greater than N4, the coding rate of the first LDPC matrix is 1/2; wherein NO is 324; N1 is 468; N2 is 648; N3 is 972; and N4 is 1932.

According to a second aspect, an embodiment of this application provides a receiving apparatus. The receiving apparatus includes a processing unit and a receiving unit. The receiving unit is configured to receive first transmission bits; the processing unit is configured to determine a first low-density parity-check LDPC matrix based on a quantity $n_1$ of the first transmission bits; and the processing unit is further configured to decode the first transmission bits based on the first LDPC matrix, to obtain information bits; wherein the quantity $n_1$ of the first transmission bits has a correspondence with a coding rate of the first LDPC matrix, including: if $n_1$ is less than N0, the coding rate of the first LDPC matrix is 5/6; if $n_1$ is greater than or equal to NO and less than N1, the coding rate of the first LDPC matrix is 5/6; if $n_1$ is greater than or equal to N1 and less than N2, the coding rate of the first LDPC matrix is 3/4; if $n_1$ is greater than or equal to N2 and less than N3, the coding rate of the first LDPC matrix is 2/3; if $n_1$ is greater than or equal to N3 and less than or equal to N4, the coding rate of the first LDPC matrix is 1/2; or if $n_1$ is greater than N4, the coding rate of the first LDPC matrix is 1/2; wherein NO is 324; N1 is 468; N2 is 648; N3 is 972; and N4 is 1932.

According to a third aspect, an embodiment of this application provides an encoding method. The method includes: determining, by a sending apparatus, a first low-density parity-check LDPC matrix based on a quantity $n_1$ of first transmission bits; encoding, by the sending apparatus, information bits based on the first LDPC matrix, to obtain the first transmission bits; andsending, by the sending apparatus, the first transmission bits; wherein the quantity $n_1$ of the first transmission bits has a correspondence with a coding rate of the first LDPC matrix, comprising: if $n_1$ is less than N0, the coding rate of the first LDPC matrix is 5/6; if $n_1$ is greater than or equal to NO and less than N1, the coding rate of the first LDPC matrix is 5/6; if $n_1$ is greater than or equal to N1 and less than N2, the coding rate of the first LDPC matrix is 3/4; if $n_1$ is greater than or equal to N2 and less than N3, the coding rate of the first LDPC matrix is 2/3; if $n_1$ is greater than or equal to N3 and less than or equal to N4, the coding rate of the first LDPC matrix is 1/2; or if $n_1$ is greater than N4, the coding rate of the first LDPC matrix is 1/2; wherein NO is 324; N1 is 468; N2 is 648; N3 is 972; and N4 is 1932

**BRIEF DESCRIPTION OF DRAWINGS**

FIG. 1 is a Tanner graph of low-density parity-check code according to the related art;

FIG. 2 is a check matrix of LDPC code according to the related art;

FIG. 3 is a schematic flowchart of data processing by a sending apparatus and a receiving apparatus according to the related art;

FIG. 4 is a schematic flowchart of data processing by another sending apparatus and another receiving apparatus according to the related art;

FIG. 5 is a diagram of a network architecture according to an embodiment of this application;

FIG. 6 is a schematic flowchart of an encoding and decoding method according to an embodiment of this application;

FIG. 7 is a schematic diagram of image segmentation according to an embodiment of this application;

FIG. 8 is a schematic flowchart of another encoding and decoding method according to an embodiment of this application;

FIG. 9(a) is a schematic diagram of a distribution of first transmission bits according to an embodiment of this application;

FIG. 9(b) is a schematic diagram of another distribution of first transmission bits according to an embodiment of this application;

FIG. 10 is a schematic flowchart of still another encoding and decoding method according to an embodiment of this application;

FIG. 11 is a schematic diagram of a distribution of second transmission bits according to an embodiment of this application;

FIG. 12(a) is a schematic diagram of a low-density generator matrix according to an embodiment of this application;

FIG. 12(b) is a schematic diagram of another low-density generator matrix according to an embodiment of this application;

FIG. 12(c) is a schematic diagram of still another low-density generator matrix according to an embodiment of this application;

FIG. 13 is a schematic diagram of a low-density generator matrix according to an embodiment of this application;

FIG. 14 is a schematic diagram of another distribution of second transmission bits according to an embodiment of this application;

FIG. 15 is a schematic diagram of another low-density generator matrix according to an embodiment of this application;

FIG. 16 is a schematic diagram of still another distribution of second transmission bits according to an embodiment of this application;

FIG. 17 is a schematic flowchart of still another encoding and decoding method according to an embodiment of this application;

FIG. 18 is a performance comparison diagram according to an embodiment of this application;

FIG. 19 is a schematic diagram of a composition of a sending apparatus according to an embodiment of this application;

FIG. 20 is a schematic diagram of a composition of a receiving apparatus according to an embodiment of this application; and

FIG. 21 is a schematic diagram of a structure of hardware of a communication apparatus according to an embodiment of this application.

**DESCRIPTION OF EMBODIMENTS**

The following describes technical solutions in embodiments of this application with reference to the accompanying drawings in embodiments of this application. In description of this application, the term "a plurality of" means two or more than two unless otherwise specified. In addition, to clearly describe the technical solutions in embodiments of this application, words such as "first" and "second" are used in embodiments of this application to distinguish between same items or similar items that have basically the same functions or purposes. A person skilled in the art may understand that the words such as "first" and "second" do not limit a quantity and an execution sequence, and the words such as "first" and "second" do not indicate a definite difference.

To make this application clearer, some concepts and processing procedures mentioned in this application are first briefly described.

## 1. Source coding

Source encoding is a transformation performed on a signal source to improve communication effectiveness, or a transformation performed on a signal source to reduce or eliminate source redundancy. Specifically, it is to find a method based on statistical characteristics of the signal source, to transform the signal source into a shortest bit sequence, so as to maximize an average amount of information carried by each bit in the shortest bit sequence while ensuring the signal source to be restored without distortion. A key indicator of source encoding is encoding efficiency.

A reverse process of source encoding is source decoding. The source decoding is a process of restoring a signal that is before source decoding, to obtain the signal source.

## 2. Channel coding

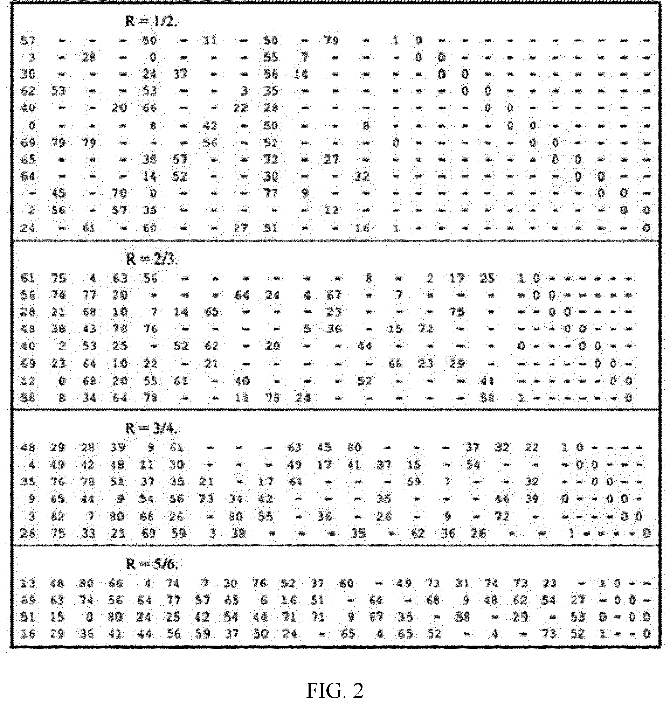

Channel encoding, also called error control encoding, means that a sending apparatus adds redundant bits to information bits (for example, source-encoded bits in FIG. 2), where the redundant bits are associated with the information bits. A channel-encoded signal includes information bits and redundant bits in sequence.

A reverse process of channel encoding is channel decoding. Channel decoding means that a receiving apparatus detects and corrects, based on an association between the redundant bits and the information bits, an error generated in a transmission process, to restore the information bits, so as to counteract interference in the transmission process and improve data transmission reliability.

## 3. Coding rate (coding rate)

The coding rate is a ratio of bits that are before encoding (that is, information bits) to encoded bits. If a bit sequence is encoded by using a coding scheme with a lower coding rate, there are more redundant bits in an encoded bit sequence, ensuring more reliable data transmission. The coding rate may be denoted as R.

## 4. Coding length

The coding length is a quantity of bits in an encoded bit sequence. When a quantity of information bits is fixed, if encoding is performed by using a coding scheme with a longer coding length, there are more redundant bits in an encoded bit sequence, ensuring more reliable data transmission.

## 5. Low-density parity-check (low-density parity-check, LDPC) code

The LDPC code is a code obtained through channel coding. The LDPC code is a standard channel coding scheme for a low-frequency short-range wireless local area network (wireless local area networks, WLAN) communication system such as the institute of electrical and electronics engineers (the institute of electrical and electronics engineers, IEEE) 802.11n/ac/ax. When a bandwidth is greater than or equal to 40 MHz, the LDPC code becomes a mandatory channel coding scheme.

The LDPC code is generally represented by a check matrix or a Tanner graph. The check matrix of the LDPC code is a sparse matrix, in which a quantity of non-zero elements is far less than a quantity of zero elements. The check matrix of the LDPC code corresponds to the Tanner graph on a one-to-one basis. The Tanner graph includes variable nodes and check nodes. The variable node represents a codeword symbol, and the check node represents a check constraint relationship. The check matrix of the LDPC code is denoted as $H$. For example, the check matrix $H$ of the LDPC code is as follows:

$$H = \begin{bmatrix} 1 & 0 & 1 & 0 & 1 & 0 & 1 & 0 \\ 1 & 0 & 0 & 1 & 0 & 1 & 0 & 1 \\ 0 & 1 & 1 & 0 & 0 & 1 & 1 & 0 \\ 0 & 1 & 0 & 1 & 1 & 0 & 0 & 1 \end{bmatrix}$$

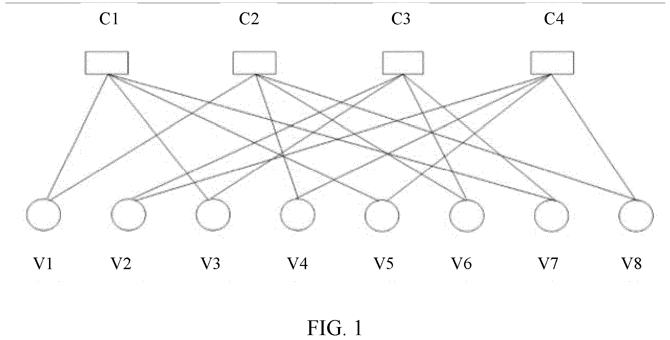

A Tanner graph corresponding to the check matrix $H$ of the LDPC code is shown in FIG. 1. In FIG. 1, $V_1$, $V_2$, $V_3$, $V_4$, $V_5$, $V_6$, $V_7$, and Vs are all variable nodes and are represented by circular nodes. $C_1$, $C_2$, $C_3$, and $C_4$ are all check nodes, and are represented by square nodes.

The LDPC code used in the IEEE802.11ac/ax standard is a quasi cyclic LDPC code (quasi cyclic low-density parity-check, QC-LDPC). A unique structure of a check matrix of the QC-LDPC code better resolves a problem of complex coding of the LDPC code. In IEEE802.11ac, the check matrix of the LDPC code supports a coding length of 1944 and a coding rate of 5/6.

For example, FIG. 2 shows check matrices of four kinds of LDPC codes, and the check matrices of the four kinds of LDPC code support a coding length of 1944. Different codewords are obtained by using the check matrices of the four kinds of LDPC codes, and a coding rate, an information bit length, and a check bit length of the codeword are as follows:

a coding rate R is 1/2, an information bit length is 972, and a check bit length is 972;
a coding rate R is 2/3, an information bit length is 1296, and a check bit length is 648;
a coding rate R is 3/4, an information bit length is 1458, and a check bit length is 486; and
a coding rate R is 5/6, an information bit length is 1620, and a check bit length is 324.

A raptor like low-density parity-check (raptor like low-density parity-check, RL-LDPC) code is an LDPC code with a coding rate of lower than 1/2.

6. Likelihood ratio (likelihood rate, LLR)

A likelihood ratio of a bit is a natural logarithm of a ratio of a probability that the bit is 1 to a probability that the bit is 0. If the probability that the bit is 1 is denoted as p(1), and the probability that the bit is 0 is denoted as p(0), the likelihood ratio of the bit is ln[p(1)/p(0)].

7. General process of data sending and receiving

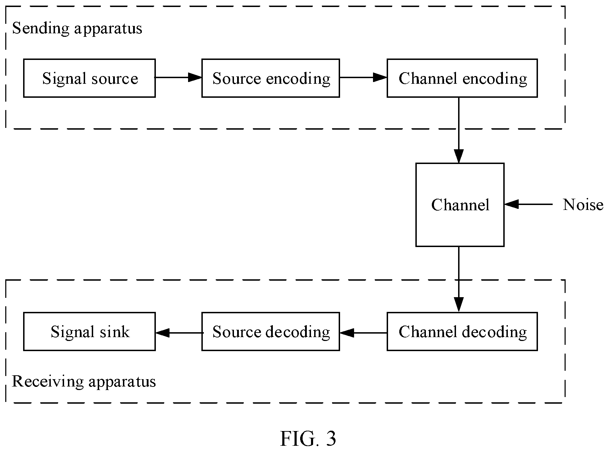

Refer to FIG. 3. In a data sending and receiving process, a sending apparatus performs source encoding, channel encoding, constellation modulation, and resource mapping on a signal source, to obtain a to-be-transmitted signal, and sends the signal to a receiving apparatus. When being transmitted over a channel between the sending apparatus and the receiving apparatus, the signal may be interfered with by noise. After receiving the signal, the receiving apparatus performs resource demapping, constellation demodulation, channel decoding, and source decoding on the signal, to obtain a signal sink (that is, a restored signal source).

FIG. 3 shows only some steps in the data sending and receiving process. In actual implementation, there may be other steps. This is not limited in embodiments of this application.

Video data transmission is used as an example. Currently, common source (for example, video data) coding methods include the following five methods. The first and the second methods are methods for performing digital-analog hybrid video coding, the third and the fourth methods are methods for performing pure digital video coding, and the fifth method is a wireless transmission method for joint source and channel transmission.

First method: SoftCast (SoftCast)

A processing process of SoftCast includes: performing discrete cosine transform (discrete cosine transform, DCT), power allocation, whitening, and resource mapping on an image and sending the image; and performing, by a receiving apparatus, linear least square estimate (linear least square estimate, LLSE) decoding and DCT inverse transformation on the received signal, to obtain the image.

Second method: Amimon's joint source and channel coding (joint source and channel coding, JSCC)

A processing process of Amimon's JSCC includes: layering an image, to obtain information about a coarse information layer and information about a fine information layer, directly performing constellation modulation and resource mapping on information about each layer, and sending a signal mapped to a transmission resource.

In both the first method and the second method, channel coding is not used, and information is directly transmitted over a channel, which is greatly affected by noise. In particular, when a signal-to-noise ratio (signal-to-noise ratio, SNR) is low, a signal received by a receiving apparatus is poor, and visual quality of a video cannot meet an actual requirement.

Third method: advanced television systems committee (advanced television systems committee, ATSC) layered division multiplexing (layered division multiplexing, LDM) and scalable high-efficiency video coding (scalable high-efficiency video coding, SHVC), which may be referred to as ATSC's LDM & SHVC for short

A processing process of ATSC's LDM & SHVC includes: layering an image (into a basic layer and an enhancement layer) based on sampling points, performing channel coding and constellation modulation for each layer, integrating information obtained after constellation modulation, and mapping the information to a transmission resource for sending.

When channel coding is performed in ATSC's LDM & SHVC, a channel coding rate is fixed. In addition, in ATSC's LDM & SHVC, the image is divided into only two layers, and therefore an ability to adapt to the channel is fairly limited.

Fourth method: FlexCast (FlexCast)

A processing process of FlexCast includes: performing DCT conversion, binary conversion, rateless coding, and resource mapping on an image, and sending the image. A rateless coded signal includes only redundant bits. Rateless coding is applicable to a binary erasure channel (binary erasure channel, BEC) and has poor performance under additive white Gaussian noise (additive white gaussian noise, AWGN). Fifth method: wireless transmission method for joint source and channel transmission

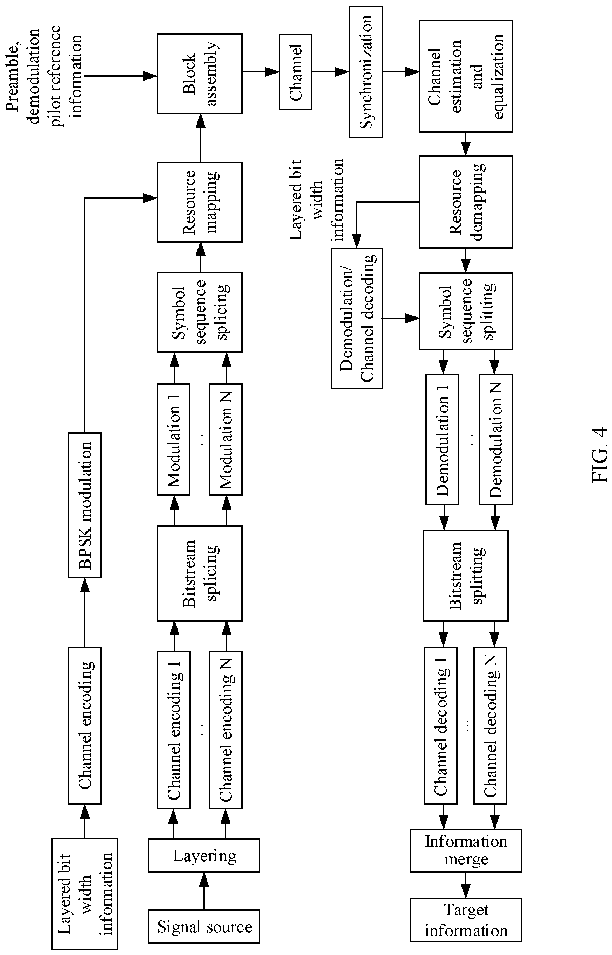

Refer to FIG. 4. A processing process of the method includes: A sending apparatus performs layering according to priorities (for example, importance) of information bits in a signal source (for example, video data or an instruction). Layered control information (for example, layered bit width information) is transmitted over a control signal channel. The control information undergoes channel encoding, binary phase shift keying (binary phase shift keying, BPSK) modulation, and resource mapping processing. A start phase of the BPSK is $\pi/2$. Layered data information (that is, the information bits) is transmitted over a data signal channel. Data information of different priorities is distributed in N bit planes. Rateless encoding is performed on data information in different bit planes separately. Bit stream splicing, symbol modulation, symbol sequence splicing, and resource mapping are performed on the encoded information. A signal is mapped to a resource block. After block (block) assembly (for example, adding a preamble (preamble) or a demodulation pilot reference signal) is performed on the signal, the signal is sent.

The layered bit width information includes a quantity of transmission bits in each bit plane, a probability that bits are 0 and a probability that bits are 1 before source encoding, and encoding-related information. N is an integer greater than 1. The control information and the data information are independently encoded and modulated. A low coding rate (for example, 1/2) coding scheme and a low-order modulation scheme (for example, BPSK) are used for the control information. For the data information, medium and low coding rates (for example, 3/4) are used for high-priority information bits, and high and medium coding rates (for example, 7/8) are used for low-priority information bits. The information bits enter N independent encoders.

The receiving apparatus performs synchronization, channel estimation, and equalization processing on the received signal, and then obtains control information and data information through resource demapping. Demodulation and channel decoding are performed on the control information, to obtain the layered bit width information. Soft information in each layer is obtained by performing symbol sequence splitting, demodulation, bit stream splitting, and the like on the data information. Then, a probability that bits are 0 or a probability that bits are 1 is obtained through channel decoding. Finally, the information is merged based on the probability, to restore original source information, that is, obtain target information. The soft information is a likelihood ratio corresponding to each bit in the data information. However, rateless coding is still used for the channel coding, with poor channel coding performance. Moreover, rateless coding cannot be applied to an existing LDPC encoding and decoding architecture.

In view of this, an embodiment of this application provides an encoding and decoding method, and a communication system to which the encoding and decoding method provided in this embodiment of this application is applicable includes a sending apparatus and a receiving apparatus. The sending apparatus is an apparatus or a chip that supports wireless communication, such as an apparatus or a chip that supports 802.11 family of protocols, or an apparatus or a chip that supports cellular communication. The sending apparatus may be a network device, a terminal, a chip in a terminal, a chip in a network device, or the like. The sending apparatus may also be described as an originating apparatus or a sending apparatus. The receiving apparatus is an apparatus or a chip that supports wireless communication, such as an apparatus or a chip that supports 802.11 family of protocols, or an apparatus or a chip that supports cellular communication. The receiving apparatus may be a network device, a terminal, a chip in a terminal, a chip in a network device, or the like. The receiving apparatus may also be described as a terminating apparatus or a receiving apparatus. In addition, the sending apparatus and the receiving apparatus may be two apparatuses in a communication system. For example, the sending apparatus may be a first apparatus in the communication system, the receiving apparatus may be a second apparatus in the communication system, and data can be exchanged between the first apparatus and the second apparatus. The network device may be a communication entity such as a communication server, a router, a switch, and a bridge, a macro base station, a micro base station, a relay station, a wireless local area network access point, or the like. The terminal may be a mobile phone, a tablet computer, a smart home device, an internet of things node, an internet of vehicles device, an augmented reality (augmented reality, AR)/virtual reality (virtual reality, VR) device, or the like.

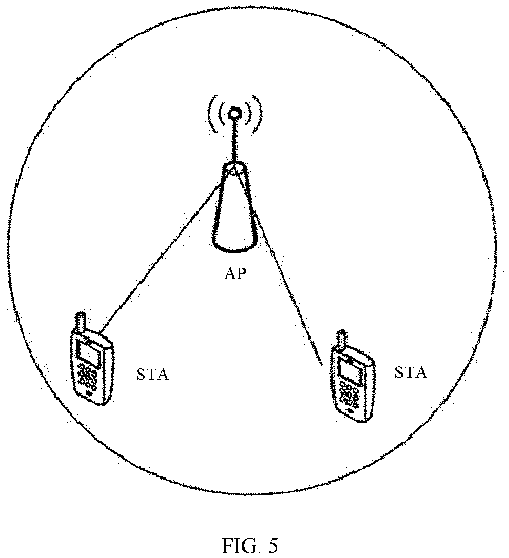

FIG. 5 shows a wireless local area network communication system to which an encoding and decoding method according to an embodiment of this application is applicable. A network device may be an access point (access point, AP) in the wireless local area network communication system, and a terminal may be a station (station, STA) in the wireless local area network communication system. Refer to FIG. 5. A system architecture of the wireless local area network includes at least one AP and at least one station (station, STA). The AP is a network element providing services for the station, and may be an access point supporting 802.11 family of protocols. The station STA may be a station supporting 802.11 family of protocols. The 802.11 family of protocols may include extremely high throughput (extremely high throughput, EHT) or IEEE 802.11be.

A network architecture and a service scenario that are described in embodiments of this application are intended to describe the technical solutions in embodiments of this application more clearly, and do not constitute a limitation on the technical solutions provided in embodiments of this application. A person of ordinary skill in the art may know that the technical solutions provided in embodiments of this application are also applicable to a similar technical problem as a network architecture evolves and a new service scenario emerges.

The following describes in detail an encoding and decoding method provided in embodiments of this application.

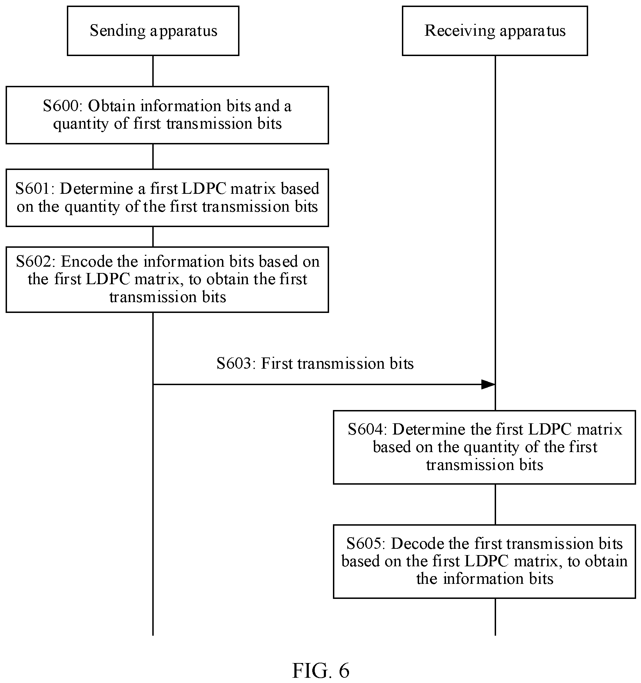

An embodiment of this application provides an encoding and decoding method. Refer to FIG. 6. The coding method includes the following steps.

S600: A sending apparatus obtains information bits and a quantity $n_1$ of first transmission bits.

The information bits are one of N layers of bit sequences obtained by layering original information. Herein, the original information is at least one bit sequence. N is an integer greater than 1. For example, the process in which "a sending apparatus obtains information bits" includes step 1 to step 3.

Step 1: The sending apparatus obtains the original information.

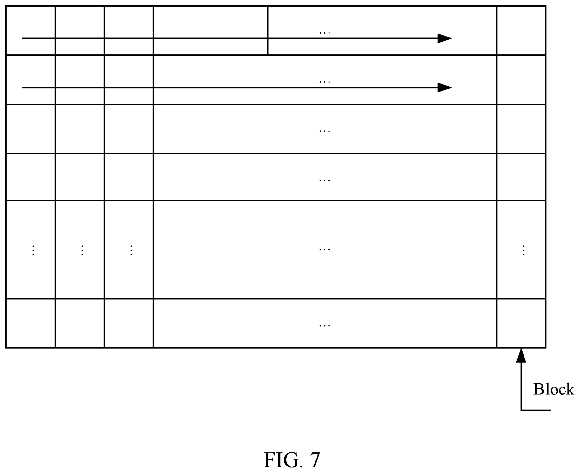

For example, refer to FIG. 7. Pixels of one frame of image are 1920 ×1080, and pixels of one block are 8×8. The frame of image is divided in unit of blocks, to obtain 135 ×240 blocks. In FIG. 7, one square represents one block. Discrete cosine transform (discrete cosine transform, DCT) or wavelet transform is performed on all pixels in one block. The DCT transform is used as an example. The DCT transform is performed on all pixels in each block, to obtain a corresponding DCT coefficient. Each DCT coefficient is quantized, to obtain a corresponding DCT quantized coefficient. Then, eight bits are used to represent DCT quantized coefficients, and a quantized bit sequence (including a plurality of bits), that is, the original information, can be obtained. The DCT coefficients are real numbers, and the DCT quantized coefficients are integers.

Step 2: The sending apparatus layers the original information, to obtain N layers of bit sequences.

The layering processing technology may be a bit-plane layering technology, or video coding technologies such as source coding (for example, scalable video coding (scalable video coding, SVC), and tile-based 306° layering (Tile-based 360°)) or other schemes may be used to layer the original information, so that all bits in the bit sequence are distributed in different bit planes, to obtain a bit sequence distributed on N layers of bit planes.

Herein, the sending apparatus layers a plurality of bits in the original information into N layers of bit sequences based on priorities of bits in the original information. For example, at a granularity of 15 DCT blocks, the bit sequences in the original information are grouped into eight layers, and a quantity of bits distributed in each layer is 960, or an integer multiple of 960.

Step 3: The sending apparatus uses any layer of the N layers of bit sequences as the information bits.

The sending apparatus may obtain the to-be-encoded information bits. Certainly, the sending apparatus may alternatively obtain the to-be-encoded information bits in other ways.

Optionally, the quantity $n_1$ of the first transmission bits is determined based on the priorities of the information bits. Different priorities of the first transmission bits distributed on different bit planes correspond to different quantities of configured first transmission bits. A higher-priority bit plane has a larger quantity of configured first transmission bits, so as to ensure data transmission reliability.

Video transmission is used as an example. Because the high-priority information bits are more critical for restoring video data, if the receiving apparatus can accurately receive this part of information, basic image quality and viewing experience can be guaranteed. Regardless of a signal-to-noise ratio (signal-to-noise ratio, SNR), the high-priority information bits correspond to key information in the video data. By virtue of a more reliable channel encoding scheme, this part of information can be well restored, regardless of whether channel quality is good or not. The low-priority information bits are insensitive to the human eyes. In the case of good channel quality and a high SNR, the receiving apparatus can restore this part of information with high quality, which enhances image quality. In the case of poor channel quality and a low SNR, if the receiving apparatus cannot restore this part of information, image quality is not greatly affected. Therefore, the higher-priority information bits correspond to a larger quantity of first transmission bits and a higher coding rate used, so as to improve the data transmission reliability. The lower-priority information bits correspond to a smaller quantity of first transmission bits and a lower coding rate used, so as to avoid wasting transmission resources. In addition, during video data transmission, if a video rate does not match a channel capacity, and a value of channel noise is greater than a predicted value, reconstructed video is greatly distorted. Moreover, when the value of channel noise is smaller than the predicted value, distortion of the reconstructed video is not reduced. Such phenomenon may be called a cliff effect. If the information bits of different priorities are configured with different quantities of the first transmission bits, the information bits of different priorities can have a strong adaptability to a channel, to avoid the cliff effect and reduce delay required for retransmission and feedback, guaranteeing low-latency video transmission.

S601: The sending apparatus determines a first LDPC matrix based on the quantity $n_1$ of the first transmission bits.

A coding length corresponding to the first LDPC matrix is fixed, to be specific, a quantity of columns of the first LDPC matrix is fixed. The quantity $n_1$ of the first transmission bits has a correspondence with a coding rate of the first LDPC matrix. A larger quantity $n_1$ of the first transmission bits means a lower coding rate of the first LDPC matrix. The following example is used.

If $n_1 \in [N_0, N_1)$ or $n_1 \in [0, N_0)$, the coding rate of the first LDPC matrix is a first coding rate.

If $n_1 \in [N_1, N_2)$, the coding rate of the first LDPC matrix is a second coding rate.

If $n_1 \in [N_2, N_3)$, the coding rate of the first LDPC matrix is a third coding rate.

If $n_1 \in [N_3, N_4)$ or $n_1 \rangle N_4$, the coding rate of the first LDPC matrix is a fourth coding rate.

The first coding rate is greater than the second coding rate, the second coding rate is greater than the third coding rate, the third coding rate is greater than the fourth coding rate, and $N_0 \langle N_1 \langle N_2 \langle N_3 \langle N_4$.

The sending apparatus may determine the coding rate of the first LDPC matrix based on the quantity of the first transmission bits, to encode the information bits. In a conventional technology, an LDPC matrix with a same coding rate is used to encode information bits, resulting in poor data transmission reliability and large transmission resource overheads. In this embodiment of this application, the sending apparatus selects the first LDPC matrix with a different coding rate based on the quantity of the first transmission bits, to encode the information bits. Different to-be-transmitted information bits correspond to different quantities of the first transmission bits, and further, to different coding rates of the selected first LDPC matrix. For the higher-priority information bits, a lower coding rate of the first LDPC matrix is selected, ensuring data transmission reliability. For the lower-priority information bits, a higher coding rate of the first LDPC matrix is selected, reducing data transmission resource overheads.

In a practical application process, the codeword obtained by encoding the information bits by using the first LDPC matrix includes three coding lengths: 648, 1296, and 1944. Video transmission is used as an example. Most packets in the video transmission are long packets, and the first LDPC matrix with a coding length of 1944 is mostly used, meaning that a quantity of columns of the first LDPC matrix is 1944. Taking the coding length of 1944, according to the present invention, $N_0$=324, $N_1$=468, $N_2$=648, $N_3$=972, and $N_4$=1932. The first coding rate is 5/6, the second coding rate is 3/4, the third coding rate is 2/3, and the fourth coding rate is 1/2. The following gives specific descriptions.

If $n_1 \in [324,468)$ or $n_1 \in [0,324)$, the coding rate of the first LDPC matrix is R = 5/6 .

If $n_1 \in [468,648)$, the coding rate of the first LDPC matrix is R = 3/4 .

If $n_1 \in [648,972)$, the coding rate of the first LDPC matrix is R = 2/3 .

If $n_1 \in [972,1932]$ or $n_1 \rangle 1932$, the coding rate of the first LDPC matrix is $R$ = 1/2.

S602: The sending apparatus encodes the information bits based on the first LDPC matrix, to obtain the first transmission bits.

Different coding rates of the first LDPC matrix lead to different bit positions of the first transmission bits in a first codeword.

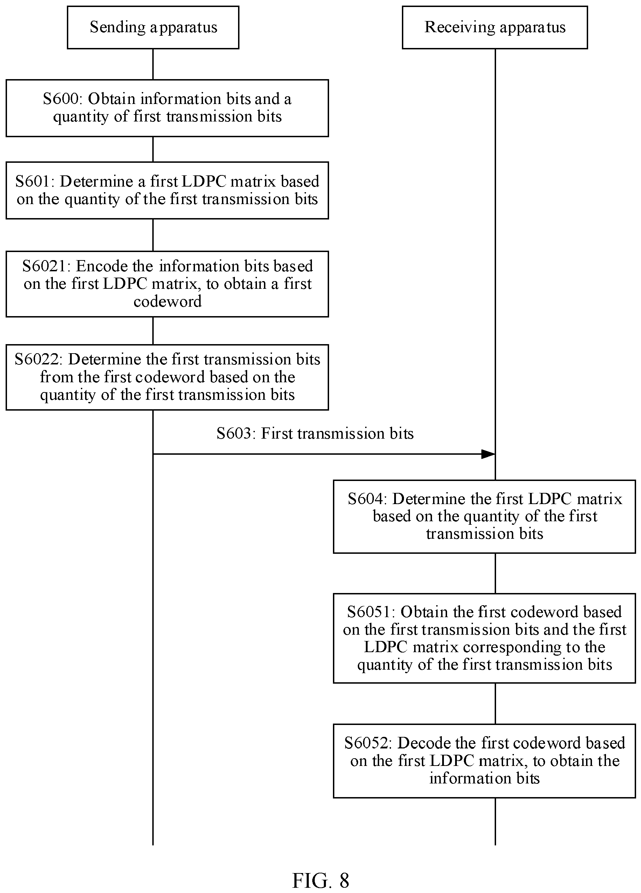

Optionally, refer to FIG. 8. A specific implementation process of S602 includes S6021 and S6022.

S6021: The sending apparatus encodes the information bits based on the first LDPC matrix, to obtain a first codeword.

The first codeword includes the information bits and $m$ check bits.

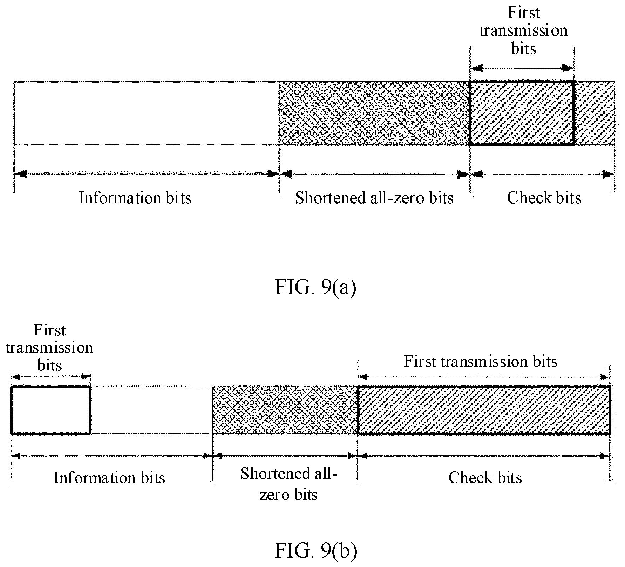

For example, the coding length is still 1944. If $n_1 \in [0,324)$ or $n_1 \in [324,468)$, the coding rate of the first LDPC matrix is $R$ = 5/6 . The information bits are encoded by using the first LDPC matrix with the coding rate of $R$ = 5/6 , to obtain the first codeword. In this case, the first codeword includes the information bits and 324 check bits (as shown in the part filled with slashes in FIG. 9(a)). If the quantity of the information bits is less than 1620, the first codeword further includes shortened all-zero bits (as shown in the part filled with grid in FIG. 9(a)). The quantity of the information bits and shortened all-zero bits is 1620.

If $n_1 \in [468,648]$, the coding rate of the first LDPC matrix is $R$ = 3/4 . The information bits are encoded by using the first LDPC matrix with the coding rate of $R$ =

3/4 , to obtain the first codeword. In this case, the first codeword includes the information bits and 486 check bits. If the quantity of the information bits is less than 1458, the first codeword further includes shortened all-zero bits. The quantity of the information bits and shortened all-zero bits is 1458.

If $n_1 \in [648,972)$, the coding rate of the first LDPC matrix is $R$ = 2/3 . The information bits are encoded by using the first LDPC matrix with the coding rate of $R$ = 2/3 , to obtain the first codeword. In this case, the first codeword includes the information bits and 648 check bits. If the quantity of the information bits is less than 1296, the first codeword further includes shortened all-zero bits. The quantity of the information bits and shortened all-zero bits is 1296.

If $n_1 \in [972,1932]$ or $n_1 \rangle 1932$, the coding rate of the first LDPC matrix is $R$ = 1/2 . The information bits are encoded by using the first LDPC matrix with the coding rate of $R$ = 1/2, to obtain the first codeword. In this case, the first codeword includes the information bits and 972 check bits (as shown in the part filled with slashes in FIG. 9(b)). If the quantity of the information bits is less than 972, the first codeword further includes shortened all-zero bits (as shown in the part filled with grids in FIG. 9(b)). The quantity of the information bits and shortened all-zero bits is 972.

S6022: The sending apparatus determines the first transmission bits from the first codeword based on the quantity $n_1$ of the first transmission bits.

Different quantities of the first transmission bits correspond to different bits included in the first transmission bits. For example, the first transmission bits include a part of $m$ check bits, or the first transmission bits include $m$ check bits, or the first transmission bits include $m$ check bits and a part of the information bits, or the first transmission bits include the first codeword; or the quantity of the first transmission bits is zero.

In an example, if $n_1 \in [0, N_0)$, the first transmission bits include the first $n_1$ bits in the $m$ check bits. Herein, the first transmission bits may alternatively be $n_1$ bits selected from the $m$ check bits according to a preset selection rule.

If $n_1 \in [N_0, N_1)$, the first transmission bits include the $m$ check bits and the first $(n_1 -m)$ bits in the information bits.

If $n_1 \in [N_1, N_2)$, the first transmission bits include the $m$ check bits and the first $(n_1 -m)$ bits in the information bits.

If $n_1 \in [N_2, N_3)$, the first transmission bits include the $m$ check bits and the first $(n_1 -m)$ bits in the information bits.

If $n_1 \in [N_3, N_4]$, the first transmission bits include the $m$ check bits and the first $(n_1 -m)$ bits in the information bits. Herein, the sending apparatus may alternatively select $(n_1 -m)$ bits from the information bits according to a preset selection rule.

If $n_1 \rangle N_4$, the first transmission bits include the information bits and the $m$ check bits. In an actual application process, because a total quantity of the information bits and the $m$ check bits is still less than $n_1$, the sending apparatus may sequentially select bits from the foregoing "information bits and $m$ check bits" until a quantity of bits is equal to $n_1$.

In this embodiment of this application, the sending apparatus determines the first transmission bits based on the quantity of the first transmission bits. Because the higher-priority information bits correspond to a larger quantity of the first transmission bits, the information bits may be encoded by using the first LDPC matrix with a low coding rate, so as to ensure information transmission reliability. Because the lower-priority information bits correspond to a smaller quantity of the first transmission bits, the information bits may be encoded by using the first LDPC matrix with a high coding rate, so as to reduce data transmission resource overheads. Compared with a method for encoding information bits of different priorities by using an LDPC matrix with a fixed coding rate, the encoding and decoding method provided in this embodiment of this application is more flexible and reliable.

For example, the coding length is 1944, $N_0$=324, $N_1$=468, $N_2$=648, $N_3$=972, and $N_4$=1932. The first coding rate is 5/6, the second coding rate is 3/4, the third coding rate is 2/3, and the fourth coding rate is 1/2. The following gives specific descriptions.

If $n_1 \in [0,324)$, the first transmission bits include a part of the 324 check bits, for example, the first $n_1$ bits, as specifically shown by the thick line box in FIG. 9(a), or the first transmission bits are a part of the 324 check bits that satisfy another selection rule.

If $n_1 \in [324,468)$, the first transmission bits include the check bits and a part of the information bits. Herein, the part of the information bits may be the first ($n_1$-324) bits in the information bits, or a part of the information bits that satisfy another selection rule.

If $n_1 \in [468,648)$, the first transmission bits include the check bits and a part of the information bits. Herein, the part of the information bits may be the first ($n_1$-468) bits in the information bits, or a part of the information bits that satisfy another selection rule.

If $n_1 \in [648,972)$, the first transmission bits include the check bits and a part of the information bits. Herein, the part of the information bits may be the first ($n_1$-648) bits in the information bits, or a part of the information bits that satisfy another selection rule.

If $n_1 \in [972,1932]$, the first transmission bits include the check bits and a part of the information bits. Herein, the part of the information bits may be the first ($n_1$-972) bits in the information bits, as specifically shown in the black line box in FIG. 9(b), or a part of the information bits that satisfy another selection rule.

If $n_1 \rangle 1932$, the first transmission bits include the information bits and $m$ check bits. For example, the sending apparatus may sequentially select bits in the foregoing "information bits and $m$ check bits" until a quantity of bits is equal to $n_1$. If all of the foregoing "information bits and $m$ check bits" are selected and a total quantity is still less than $n_1$, the sending apparatus sequentially selects bits from the foregoing "information bits and $m$ check bits" again until the quantity of bits is equal to $n_1$.

S603: The sending apparatus sends the first transmission bits to a receiving apparatus. Correspondingly, the receiving apparatus receives the first transmission bits from the sending apparatus.

S604: The receiving apparatus determines the first LDPC matrix based on the quantity $n_1$ of the first transmission bits.

The quantity $n_1$ of the first transmission bits has a correspondence with a coding rate of the first LDPC matrix. For details, refer to the related description in S601, which is not repeated herein.

S605: The receiving apparatus decodes the first transmission bits based on the first LDPC matrix, to obtain the information bits.

Optionally, refer to FIG. 8. A specific implementation process of S605 includes S6051 and 56052.

S6051: The receiving apparatus obtains the first codeword based on the first transmission bits and the first LDPC matrix corresponding to the quantity $n_1$ of the first transmission bits.

For example, if $n_1 \in [0,324)$, that is, the first transmission bits include the first $n_1$ bits in the 324 check bits, the first codeword includes the first transmission bits and other bits. The other bits include other information bits and other check bits. An LLR value of the other information bits in the other bits is a first LLR value, and the first LLR value is a value determined based on information about a ratio of 0s or 1s in the information bits. An LLR value of the other check bits in the other bits is 0. The receiving apparatus determines values of the other information bits based on the first LLR value, and then determines values of the other check bits other than the "the part of the check bits included in the first transmission bits" based on the LLR value of the other check bits, meaning that the other check bits are assigned to 0. Herein, the "information about a ratio of 0s or 1s in the information bits" is also information transmitted from the sending apparatus to the receiving apparatus.

If $n_1 \in [324,468)$, or $n_1 \in [468,648)$, or $n_1 \in [648,972)$, or $n_1 \in [972,1932]$, that is, the first transmission bits include the check bits and a part of the information bits, the first codeword includes the first transmission bits and other bits. The other bits include other information bits. The receiving apparatus still determines values of the other information bits other than the "the part of the information bits included in the first transmission bits" based on the first LLR value.

If $n_1 \rangle 1932$, that is, the first transmission bits include the information bits and $m$ check bits, the first codeword includes the first transmission bits.

S6052: The receiving apparatus decodes the first codeword by using the first LDPC matrix, to obtain the information bits.

For example, if $n_1 \in [0,324)$ or $n_1 \in [324,468)$, the coding rate of the first LDPC matrix is $R = 5/6$. The first codeword is decoded by using the first LDPC matrix with the coding rate of $R = 5/6$, to obtain the information bits.

If $n_1 \in [468,648)$, the coding rate of the first LDPC matrix is $R = 3/4$. The first codeword is decoded by using the first LDPC matrix with the coding rate of $R = 3/4$, to obtain the information bits.

If $n_1 \in [648,972)$, the coding rate of the first LDPC matrix is $R = 2/3$. The first codeword is decoded by using the first LDPC matrix with the coding rate of $R = 2/3$, to obtain the information bits.

If $n_1 \in [972,1932]$ or $n_1 \rangle 1932$, the coding rate of the first LDPC matrix is R = 1/2. The first codeword is decoded by using the first LDPC matrix with the coding rate of $R = 1/2$, to obtain the information bits.

In the encoding and decoding method provided in this embodiment of this application, the sending apparatus determines the corresponding first LDPC matrix based on the quantity of the first transmission bits. Different quantities of the first transmission bits correspond to different coding rates of the first LDPC matrix. To be specific, the first LDPC matrix with a different coding rate can be flexibly determined based on the quantity of the first transmission bits, improving flexibility and reliability of encoding and decoding. The coding rate of the first LDPC matrix is flexible, and therefore the sending apparatus can encode the information bits by flexibly using the first LDPC matrix with different coding rates. In the case of a large quantity of the first transmission bits, the information bits are encoded by using the first LDPC matrix with a low coding rate, to obtain the first transmission bits, thereby ensuring data transmission reliability. In the case of a small quantity of the first transmission bits, the information bits are encoded by using the first LDPC matrix with a high coding rate, to obtain the first transmission bits, thereby saving transmission resources. In addition, the encoding and decoding method provided in this embodiment of this application can be applied to an LDPC codec of an existing WLAN, with a flexible coding rate.

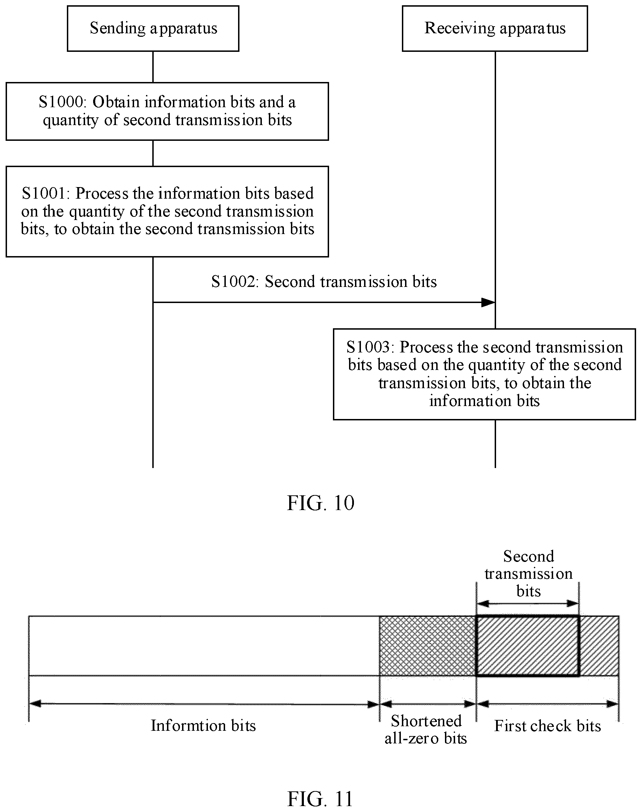

In all of the foregoing descriptions, encoding and decoding are performed at a fixed coding length. In addition, an embodiment of this application further provides an encoding and decoding method for a case in which a quantity of information bits is fixed. Refer to FIG. 10. The encoding method includes the following steps.

S1000: A sending apparatus obtains information bits and a quantity $n_2$ of second transmission bits.

For specific implementation process of S1000, refer to related description in S600. Details are not described herein again.

For example, at a granularity of 25 DCT blocks, bit sequences in original information are grouped into eight layers, and a quantity of bits distributed in each layer is 1600, or an integer multiple of 1600.

S1001: The sending apparatus processes the information bits based on the quantity $n_2$ of the second transmission bits, to obtain the second transmission bits.

Different values of the quantity $n_2$ of the second transmission bits make different processing on the information bits by the sending apparatus and different second transmission bits. Details are as follows.

If $n_2 \in [0, N_0)$ and $N_0 = 324$, a specific implementation process of S1001 includes step 1 and step 2.

Step 1: The sending apparatus encodes the information bits by using an LDPC matrix with a coding rate of 5/6, to obtain a first codeword, where the first codeword includes first check bits.

A coding length corresponding to the LDPC matrix is 1944, meaning that a quantity of columns of the LDPC matrix is 1944. A coding length of the first codeword is 1944. The first codeword includes the information bits (as shown by an unfilled box in FIG. 11), shortened all-zero bits (as shown by a box filled with grids in FIG. 11), and check bits (as shown by a box filled with slashes in FIG. 11).

Step 2: The sending apparatus determines that the second transmission bits are the first $n_2$ check bits (as shown by the thick black line box in FIG. 11) in the first check bits. Herein, the second transmission bits may alternatively be $n_2$ bits selected from the first check bits according to a preset selection rule.

If $n_2 \in [N_0, N_5]$, where $N_5$ is a maximum quantity of check bits supported by an encoding and decoding system, a specific implementation process of S1001 includes step 1, step 3, and step 4.

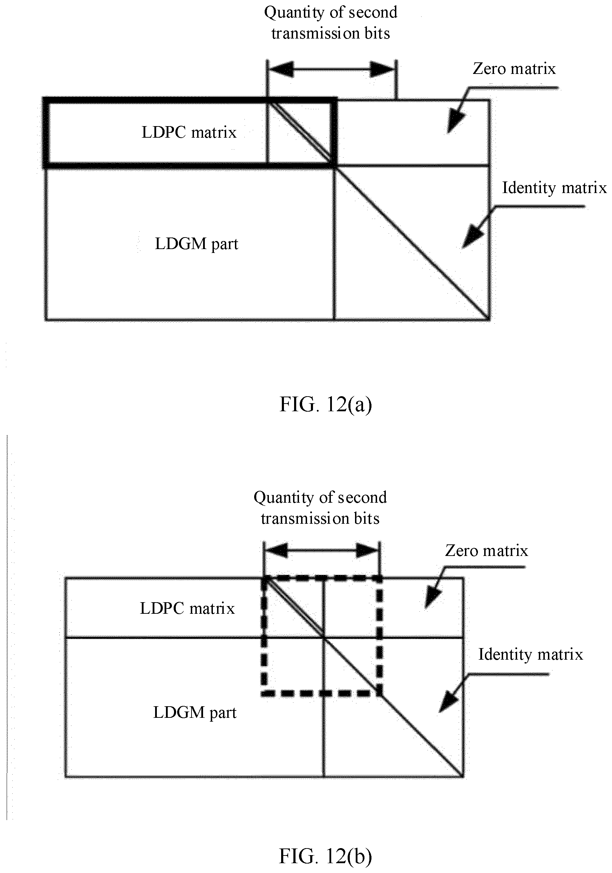

Step 1: The sending apparatus encodes the information bits by using an LDPC matrix with a coding rate of 5/6, to obtain a first codeword, where the first codeword includes first check bits. The LDPC matrix with a coding rate of 5/6 is shown by the thick black line box in FIG. 12(a).

Step 3: The sending apparatus encodes the first codeword by using a low-density generator matrix (low density generator matrix, LDGM), to obtain a second codeword.

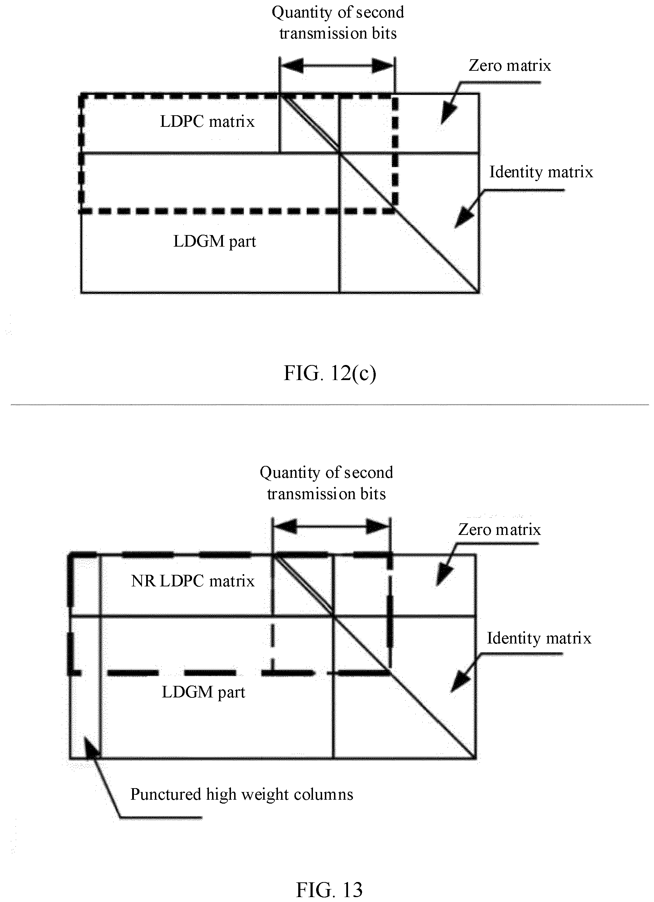

The LDGM is determined based on the quantity of the second transmission bits. Refer to FIG. 12(a), FIG. 12(b), or FIG. 12(c). A check matrix of an RL-LDPC code includes a core matrix and an extension part. The core matrix is an LDPC matrix used by a WLAN chip (for example, an LDPC matrix that supports a coding length of 1944 and a coding rate of 5/6), as shown by the thick black line box in FIG. 12(a), and the LDPC matrix includes a check part with a double-diagonal structure. The extension part includes an LDGM part and an identity matrix. A quantity of rows in the LDGM is determined by $(n_2 - N_0)$. In FIG. 12(b), the quantity of rows in the LDGM can be determined from the square thick black dotted box. In FIG. 12(c), the rectangular thick black dotted box shows the LDGM for encoding the first codeword. In addition, the core matrix may alternatively be an LDPC channel encoding part of a data channel for a new radio (new radio, NR) chip. Refer to FIG. 13. The rectangular black dotted box in FIG. 13 shows an LDGM for encoding the first codeword. In this case, no information bits corresponding to punctured high weight columns (punctured high weight columns) in the check matrix of the RL-LDPC code are transmitted.

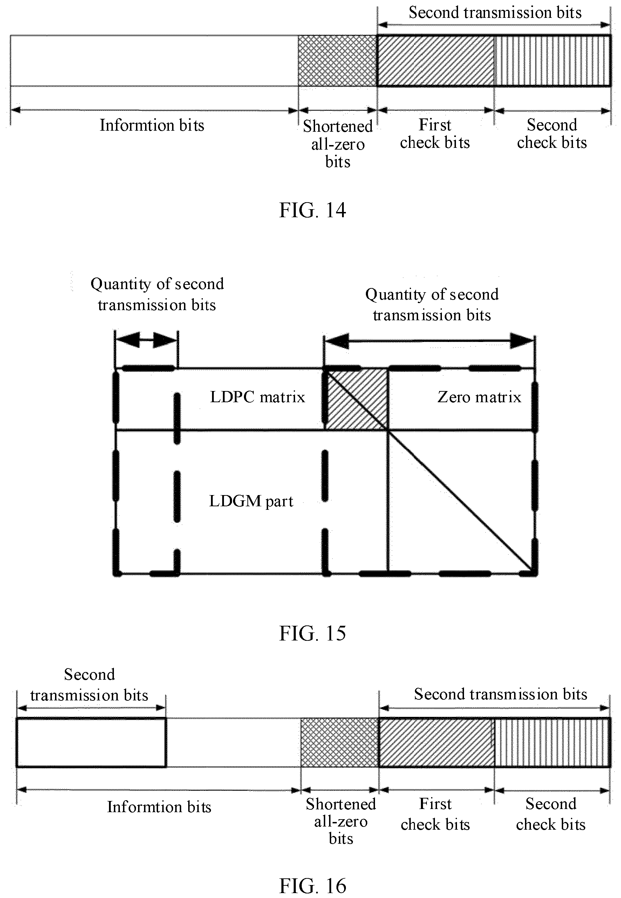

The second codeword includes second check bits (as shown by the box filled with vertical lines in FIG. 14).

Step 4: The sending apparatus determines that the second transmission bits include the first check bits and the second check bits, where a sum of a quantity of the first check bits and a quantity of the second check bits is $n_2$ (as shown by the black line box in FIG. 14).

If $n_2 \rangle N_5$, a specific implementation process of S1001 includes step 1, step 3, and step 5.

Step 1: The sending apparatus encodes the information bits by using an LDPC matrix with a coding rate of 5/6, to obtain a first codeword, where the first codeword includes first check bits.

Step 3: The sending apparatus encodes the first codeword by using an LDGM, to obtain a second codeword.

For example, refer to FIG. 15. In the LDGM part, the part covered by the black dotted box is the LDGM for encoding the first codeword.

Step 5: The sending apparatus determines that the second transmission bits include the first $(n_2 \text{-} N_5)$ information bits in the information bits, the first check bits, and the second check bits (as shown by the black line box in FIG. 16).

Based on the foregoing steps 1 to 5, the sending apparatus can flexibly match different coding rates by using the LDGM, to encode the information bits.

S1002: The sending apparatus sends the second transmission bits to a receiving apparatus. Correspondingly, the receiving apparatus receives the second transmission bits from the sending apparatus.

S1003: The receiving apparatus processes the second transmission bits based on a quantity $n_2$ of the second transmission bits, to obtain the information bits.

Different quantities $n_2$ of the second transmission bits correspond to different second transmission bits. The following example is used.

If $n_2 \in [0, N_0)$ and $N_0$=324, the second transmission bits are the first $n_2$ check bits in the first check bits.

If $n_2 \in [N_0, N_5]$, where $N_5$ is a maximum quantity of check bits supported by an encoding and decoding system, the second transmission bits include the first check bits and the second check bits.

If $n_2 \rangle N_5$, the second transmission bits include the first $(n_2 \text{-} N_5)$ information bits in the information bits, the first check bits, and the second check bits. The first check bits are obtained by encoding the information bits based on an LDPC matrix with a coding rate of 5/6, and the second check bits are obtained by encoding the information bits and the first check bits based on an LDGM matrix.

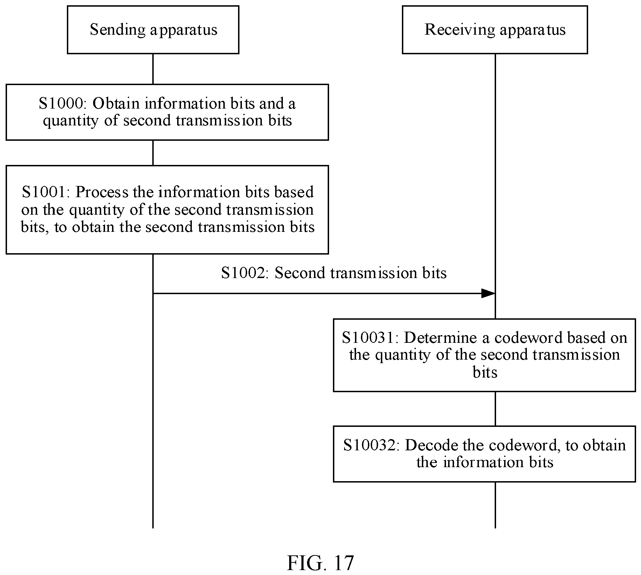

Optionally, refer to FIG. 17. A specific implementation process of S1003 includes S10031 and S10032.

S10031: The receiving apparatus determines a codeword based on the quantity $n_2$ of the second transmission bits.

Specifically, if $n_2 \in [0, N_0)$ and $N_0$=324, the second transmission bits include the first check bits, the codeword includes the second transmission bits and other bits, and the other bits are information bits. In other words, the codeword includes the first check bits and the information bits.

If $n_2 \in [N_0, N_5]$, where $N_5$ is a maximum quantity of check bits supported by an encoding and decoding system, the second transmission bits include the first check bits and the second check bits, the codeword includes the second transmission bits and other bits, and the other bits are information bits. In other words, the codeword includes the first check bits, the second check bits, and the information bits.

If $n_2 \rangle N_5$, the second transmission bits include the first $(n_2 \text{-} N_5)$ information bits in the information bits, the first check bits, and the second check bits. The codeword includes the second transmission bits and other bits, and the other bits are a part of the information bits. In other words, the codeword includes the first check bits, the second check bits, and the information bits.

S10032: The receiving apparatus decodes the codeword, to obtain the information bits.

Specifically, if $n_2 \in [0, N_0)$, a specific implementation process of S10032 includes step 1.

Step 1: The receiving apparatus decodes the codeword by using an LDPC matrix with a coding rate of 5/6, to obtain the information bits.

A coding length supported by the LDPC matrix is 1944, meaning that a quantity of columns of the LDPC matrix is 1944.

If $n_2 \in [N_0, N_5]$ or $n_2 \rangle N_5$, a specific implementation process of S10032 includes step 2 and step 1.

Step 2: The receiving apparatus decodes the codeword by using an LDGM matrix, to obtain a first codeword.

The first codeword includes the information bits and the first check bits.

Step 1: The receiving apparatus decodes the first codeword by using an LDPC matrix with a coding rate of 5/6, to obtain the information bits.

A coding length corresponding to the LDPC matrix is 1944.

The receiving apparatus performs different processing on the second transmission bits based on the quantity of the second transmission bits, to obtain the corresponding information bits.

In the encoding and decoding method provided in this embodiment of this application, the sending apparatus processes the information bits based on the quantity of the second transmission bits, to obtain the second transmission bits of a corresponding quantity. Different quantities of the second transmission bits correspond to different processes for processing the information bits. To be specific, based on the quantity of the second transmission bits, the receiving apparatus may perform processing on the information bits by using different coding rates, so that the sending apparatus can flexibly match different coding rates. The sending apparatus performs corresponding processing on the information bits based on the quantity of the second transmission bits, to obtain the second transmission bits of a corresponding quantity. In the case of a large quantity of the second transmission bits, the information bits are encoded by using a matrix with a low coding rate, to obtain the second transmission bits, thereby ensuring data transmission reliability. In the case of a small quantity of the second transmission bits, the information bits are encoded by using a matrix with a high coding rate, to obtain the second transmission bits, thereby saving transmission resources.

Both of the two encoding and decoding methods proposed in this application can be applied to a data processing process shown in FIG. 4. Refer to FIG. 4. The sending apparatus performs layering according to priorities of information bits in video data. Layered control information (for example, layered bit width information) is transmitted over a control signal channel. The control information undergoes channel encoding, BPSK modulation, and resource mapping. Layered information bits are transmitted over a data signal channel. Data information of different priorities is distributed in different bit planes. The following uses two bit planes as an example to separately illustrate the two encoding and decoding methods.

Example 1: The first encoding and decoding method is used.

Different quantities of the first transmission bits are configured for the two bit planes. The sending apparatus separately executes S600, S601, and 5602 on data information in different bit planes, to obtain first transmission bits in the first bit plane and first transmission bits in the second bit plane. For example, for the information bits distributed in the first bit plane, a quantity of the first transmission bits is 323, a coding rate of the first LDPC matrix is 5/6, and a quantity of columns in the first LDPC matrix is 1944. The sending apparatus encodes the information bits in the first bit plane by using the first LDPC matrix with the coding rate of 5/6, to obtain a codeword with a coding length of 1944, and further obtains the first transmission bits in the first bit plane. For the information bits distributed in the second bit plane, a quantity of the first transmission bits is 649, and a coding rate of the first LDPC matrix is 2/3. The sending apparatus encodes the information bits in the second bit plane by using the first LDPC matrix with the coding rate of 2/3, to obtain a codeword with a coding length of 1944, and further obtains the first transmission bits in the second bit plane. The sending apparatus performs bit stream splicing, symbol modulation, symbol sequence splicing, and resource mapping on encoded information, and maps a signal to a resource block. After block (block) assembly (for example, adding a preamble (preamble) or a demodulation pilot reference signal) is performed on the signal, the sending apparatus sends the signal.

The receiving apparatus performs synchronization, channel estimation, and equalization processing on the received signal, and then obtains control information and data information through resource demapping. Demodulation and channel decoding are performed on the control information, to obtain the layered bit width information. Symbol sequence splitting, demodulation, bit stream splitting, and the like are performed on the data information, to obtain the first transmission bits of each layer, and then S604 and S605 are executed, to obtain the information bits of each layer. For example, for the first transmission bits distributed in the first bit plane, the quantity of the first transmission bits is 323, and the receiving apparatus determines that a coding length of the first codeword including the first transmission bits is 1944. The receiving apparatus determines values of the other information bits in the first codeword based on a first LLR value of the control information. The receiving apparatus then decodes the first codeword in the first bit plane by using the first LDPC matrix with a coding rate of 5/6, to obtain the information bits in the first bit plane. For the first transmission bits distributed in the second bit plane, the quantity of the first transmission bits is 649, and the receiving apparatus determines that a coding length of the first codeword including the first transmission bits is 1944. The receiving apparatus determines values of the other information bits in the first codeword based on a first LLR value of the control information. The receiving apparatus then decodes the first codeword by using the first LDPC matrix with a coding rate of 2/3, to obtain the information bits in the second bit plane. The receiving apparatus restores original source information based on the information bits of each layer, that is, obtains target information.

Example 2: The second encoding and decoding method is used.

Different quantities of the second transmission bits are configured for the two bit planes. The sending apparatus separately executes S1000 and S1001 on data information in different bit planes, to obtain second transmission bits in the first bit plane and second transmission bits in the second bit plane. For example, for the information bits distributed in the first bit plane, a quantity of the second transmission bits is 323, and a coding rate of the LDPC matrix is 5/6. The sending apparatus encodes the information bits in the first bit plane by using the LDPC matrix with the coding rate of 5/6, to obtain a codeword with a coding length of 1944, and further obtains the second transmission bits in the first bit plane. For the information bits distributed in the second bit plane, a quantity of the second transmission bits is 649. The sending apparatus encodes the information bits in the second bit plane by using the LDPC matrix with the coding rate of 5/6, to obtain a codeword with a coding length of 1944, encodes the codeword with the coding length of 1944 by using the LDGM, and further obtains the second transmission bits in the second bit plane. Bit stream splicing, symbol modulation, symbol sequence splicing, and resource mapping are performed on encoded information, and a signal is mapped to a resource block. After block (block) assembly (for example, adding a preamble (preamble) or a demodulation pilot reference signal) is performed on the signal, the sending apparatus sends the signal.

The receiving apparatus performs synchronization, channel estimation, and equalization processing on the received signal, and then obtains control information and data information through resource demapping. Demodulation and channel decoding are performed on the control information, to obtain the layered bit width information. Symbol sequence splitting, demodulation, bit stream splitting, and the like are performed on the data information, to obtain the second transmission bits of each layer, and then S1003 is executed, to obtain the information bits of each layer. For example, for the second transmission bits distributed in the first bit plane, the quantity of the second transmission bits is 323, and the receiving apparatus determines that the quantity of the information bits in the codeword corresponding to the second transmission bits is 1620. The receiving apparatus determines values of the other information bits in the codeword based on a first LLR value of the control information. The receiving apparatus then decodes the codeword in the first bit plane by using the LDPC matrix with a coding rate of 5/6, to obtain the information bits in the first bit plane. For the second transmission bits distributed in the second bit plane, the quantity of the second transmission bits is 649, and the receiving apparatus determines that the quantity of the information bits in the codeword corresponding to the second transmission bits is 1620. The receiving apparatus determines values of the other information bits in the codeword based on a first LLR value of the control information. The receiving apparatus first decodes the codeword by using an LDGM, to obtain a second codeword. The second codeword includes the information bits, the first check bits, and the second check bits. The receiving apparatus then decodes the second codeword by using the first LDPC matrix with a coding rate of 2/3, to obtain the information bits in the second bit plane. Finally, the receiving apparatus restores original source information based on the information bits of each layer, that is, obtains target information.

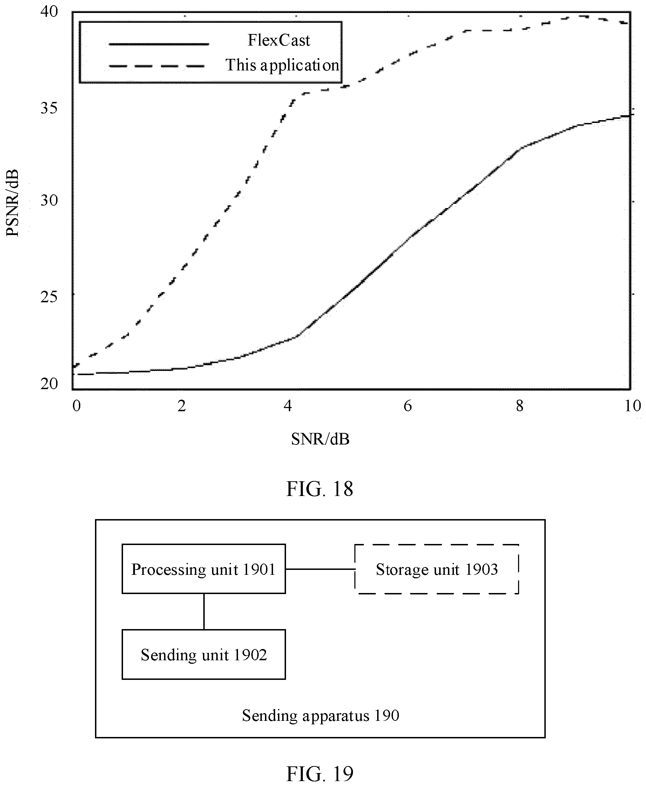

In addition, compared with a rateless coding scheme, the encoding and decoding method provided in this embodiment of this application can increase a peak signal-to-noise ratio of video data transmission. For example, a coding rate of the rateless coding is the same as the coding rate of this application, and both are 1/2. Refer to FIG. 18. In a case in which the coding rates are the same in FIG. 18, compared with the rateless coding scheme, the encoding and decoding method provided in this embodiment of this application has a good peak signal-to-noise ratio (peak signal to noise ratio, PSNR). A horizontal axis in FIG. 18 is a signal-to-noise ratio in dB. A longitudinal axis in FIG. 18 is a PSNR in dB. The PSNR is a variable for measuring image quality. If the PSNR is lower than or equal to 20 dB, the image quality is too poor to be accepted. If the PSNR is higher than 20 dB, the image quality is acceptable.

The solutions provided in embodiments of this application are mainly described above from the perspective of interaction between network elements. It may be understood that, to implement the foregoing functions, the sending apparatus and the receiving apparatus include corresponding hardware structures and/or software modules for executing the functions. A person skilled in the art should easily be aware that, in combination with units and algorithm steps of the examples described in embodiments disclosed in this specification, this application may be implemented by hardware or a combination of hardware and computer software. Whether a function is performed by hardware or hardware driven by computer software depends on particular applications and design constraints of the technical solutions. A person skilled in the art may use different methods to implement the described functions for each particular application, but it should not be considered that the implementation goes beyond the scope of this application.

For example, FIG. 19 is a schematic diagram of structure of a sending apparatus 190. The sending apparatus may be a network device or a terminal, or may be a chip in a network device or a chip in a terminal, and is configured to implement the method relating to the sending apparatus in any of the foregoing embodiments. The sending apparatus 190 includes a processing unit 1901 and a sending unit 1902, and optionally, may further include a storage unit 1903. The sending unit 1902 may be a transmitter circuit, a transmitting machine, a transmitter, a communication interface, or an input/output interface. The processing unit 1901 may be a processing circuit, a processor, or the like.

In a first possible implementation, the sending apparatus 190 is configured to implement the steps of the sending apparatus in the method embodiment corresponding to FIG. 6. For example, the processing unit is configured to determine a first low-density parity-check LDPC matrix based on a quantity $n_1$ of first transmission bits; the processing unit is further configured to encode information bits based on the first LDPC matrix, to obtain the first transmission bits; and the sending unit is configured to send the first transmission bits.

In a possible design, that the processing unit is configured to encode information bits based on the first LDPC matrix, to obtain the first transmission bits includes: The processing unit is configured to: encode the information bits based on the first LDPC matrix, to obtain a first codeword, where the first codeword includes the information bits and m check bits; and determine the first transmission bits from the first codeword based on the quantity $n_1$ of the first transmission bits.

In a possible design, if $n_1$ is less than 324, the first transmission bits include the first $n_1$ bits in 324 check bits.

If $n_1$ is greater than or equal to 324 and less than 468, the first transmission bits include 324 check bits and the first ($n_1$ -324) bits in the information bits.

If $n_1$ is greater than or equal to 468 and less than 648, the first transmission bits include 468 check bits and the first ($n_2$ $n_1$ -468) bits in the information bits.

If $n_1$ is greater than or equal to 648 and less than 972, the first transmission bits include 648 check bits and the first ($n_2$ $n_1$ -648) bits in the information bits.

If $n_1$ is greater than or equal to 972 and less than or equal to 1932, the first transmission bits include the 972 check bits and the first ($n_2$ $n_1$ -972) bits in the information bits.

If $n_1$ is greater than 1932, the first transmission bits include the information bits and 972 check bits.

In a possible design, if $n_1$ is less than 324, the coding rate of the first LDPC matrix is 5/6.

If $n_1$ is greater than or equal to 324 and less than 468, the coding rate of the first LDPC matrix is 5/6.

If $n_1$ is greater than or equal to 468 and less than 648, the coding rate of the first LDPC matrix is 3/4.

If $n_1$ is greater than or equal to 648 and less than 972, the coding rate of the first LDPC matrix is 2/3.

If $n_1$ is greater than or equal to 972 and less than or equal to 1932, the coding rate of the first LDPC matrix is 1/2.

If $n_1$ is greater than 1932, the coding rate of the first LDPC matrix is 1/2.

In a second possible implementation, the sending apparatus 200 is configured to implement the steps of the sending apparatus in the method embodiment corresponding to FIG. 10. For example, the processing unit is configured to obtain information bits and obtain a quantity $n_2$ of second transmission bits. The processing unit is further configured to perform processing on the information bits based on the quantity $n_2$ of the second transmission bits, to obtain the second transmission bits. The sending unit is configured to send the second transmission bits.

In a possible design, if $n_2$ is less than 324, that the processing unit is configured to perform processing on information bits based on the quantity $n_2$ of the second transmission bits, to obtain the second transmission bits includes: The processing unit is configured to encode the information bits by using a low-density parity-check LDPC matrix with a coding rate of 5/6, to obtain a first codeword, where the first codeword includes first check bits. The processing unit is further configured to determine that the second transmission bits are the first $n_2$ check bits in the first check bits.

If $n_2$ is greater than or equal to 324 and less than or equal to N5, where N5 is a maximum quantity of check bits supported by an encoding and decoding system, that the processing unit is configured to perform processing on information bits based on the quantity $n_2$ of the second transmission bits, to obtain the second transmission bits includes: The processing unit is configured to encode the information bits by using a low-density parity-check LDPC matrix with a coding rate of 5/6, to obtain a first codeword, where the first codeword includes first check bits. The processing unit is further configured to encode the first codeword by using a low-density generator matrix LDGM, to obtain a second codeword, where the second codeword includes second check bits. The processing unit is further configured to determine that the second transmission bits include the first check bits and the second check bits, where a sum of a quantity of the first check bits and a quantity of the second check bits is $n_2$.

If $n_2$ is greater than N5, that the processing unit is configured to perform processing on information bits based on the quantity $n_2$ of the second transmission bits, to obtain the second transmission bits includes: The processing unit is configured to encode the information bits by using a low-density parity-check LDPC matrix with a coding rate of 5/6, to obtain a first codeword, where the first codeword includes first check bits. The processing unit is further configured to encode the first codeword by using a low-density generator matrix LDGM, to obtain a second codeword, where the second codeword includes second check bits. The processing unit is further configured to determine that the second transmission bits include the first ($n_2$ -N5) information bits in the information bits, the first check bits, and the second check bits.

All related content of the steps in the foregoing method embodiments may be referenced to function descriptions of a corresponding function module, and details are not described herein again.

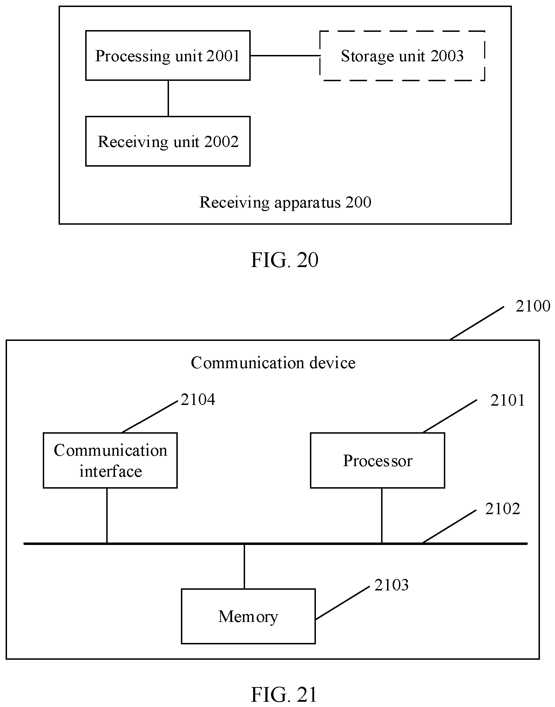

For example, FIG. 20 is a schematic diagram of a structure of a receiving apparatus 200. The receiving apparatus may be a network device or a terminal, or may be a chip in a network device or a chip in a terminal, and is configured to implement the method relating to the receiving apparatus in any of the foregoing embodiments. The receiving apparatus 200 includes a processing unit 2001 and a receiving unit 2002, and optionally, may further include a storage unit 2003. The receiving unit 2002 may be a receiver circuit, a receiving machine, a receiver, a communication interface, or an input/output interface. The processing unit 1901 may be a processing circuit, a processor, or the like.

In a first possible implementation, the receiving apparatus 200 is configured to implement the steps of the receiving apparatus in the method embodiment corresponding to FIG. 6. For example, the receiving unit is configured to receive first transmission bits. The processing unit is configured to determine a first low-density parity-check LDPC matrix based on a quantity $n_1$ of the first transmission bits. The processing unit is further configured to decode the first transmission bits based on the first LDPC matrix, to obtain information bits.

In a possible design, that the processing unit is configured to decode the first transmission bits based on the first LDPC matrix, to obtain information bits includes: The processing unit is configured to obtain a first codeword based on the first transmission bits and the first low-density parity-check LDPC matrix corresponding to the quantity $n_1$ of the first transmission bits, where the first codeword includes the first transmission bits and other bits, the other bits include other information bits and other check bits, an LLR value of the other information bits in the other bits is a first LLR value, and an LLR value of the other check bits in the other bits is 0. The processing unit is further configured to decode the first codeword by using the first LDPC matrix, to obtain the information bits.

In a possible design, the quantity $n_1$ of the first transmission bits has a correspondence with a coding rate of the first LDPC matrix.

In a possible design, if $n_1$ is less than 324, the first transmission bits include the first $n_1$ bits in 324 check bits.

If $n_1$ is greater than or equal to 324 and less than 468, the first transmission bits include 324 check bits and the first ($n_2 n_1$ -324) bits in the information bits.

If $n_1$ is greater than or equal to 468 and less than 648, the first transmission bits include 468 check bits and the first ($n_2 n_1$ -468) bits in the information bits.

If $n_1$ is greater than or equal to 648 and less than 972, the first transmission bits include 648 check bits and the first ($n_2 n_1$ -648) bits in the information bits.

If $n_1$ is greater than or equal to 972 and less than or equal to 1932, the first transmission bits include the 972 check bits and the first ($n_1$ -972) bits in the information bits.

If $n_1$ is greater than 1932, the first transmission bits include the information bits and 972 check bits.

In a possible design, if $n_1$ is less than 324, the coding rate of the first LDPC matrix is 5/6.

If $n_1$ is greater than or equal to 324 and less than 468, the coding rate of the first LDPC matrix is 5/6.

If $n_1$ is greater than or equal to 468 and less than 648, the coding rate of the first LDPC matrix is 3/4.

If $n_1$ is greater than or equal to 648 and less than 972, the coding rate of the first LDPC matrix is 2/3.

If $n_1$ is greater than or equal to 972 and less than or equal to 1932, the coding rate of the first LDPC matrix is 1/2.

If $n_1$ is greater than 1932, the coding rate of the first LDPC matrix is 1/2.

In a possible design, that the processing unit is configured to decode the first transmission bits based on the first LDPC matrix, to obtain information bits includes: The processing unit is configured to obtain a first codeword based on the first transmission bits and a first low-density parity-check LDPC matrix corresponding to the quantity $n_1$ of the first transmission bits. The first codeword includes the first transmission bits and other bits, the other bits include other information bits and other check bits, an LLR value of the other information bits in the other bits is a first LLR value, and an LLR value of the other check bits in the other bits is 0. The processing unit is configured to decode the first codeword by using the first LDPC matrix, to obtain the information bits.

In a possible design, the first LLR value is a value determined based on information about a ratio of 0s or 1s in the information bits. The receiving apparatus can determine, based on the first LLR value, the information bits not included in the first transmission bits, to accurately determine the first codeword.

In a second possible implementation, the receiving apparatus 200 is configured to implement the steps of the receiving apparatus in the method embodiment corresponding to FIG. 10. For example, the receiving unit is configured to receive the second transmission bits. The processing unit is configured to perform processing on the second transmission bits based on a quantity $n_2$ of the second transmission bits, to obtain information bits.

In a possible design, that the processing unit is configured to perform processing on the second transmission bits based on a quantity $n_2$ of the second transmission bits, to obtain information bits includes: The processing unit is configured to determine a codeword based on the quantity $n_2$ of the second transmission bits, where the codeword includes the second transmission bits and other bits, an LLR value of information bits in the other bits is a second LLR value, and an LLR value of check bits in the other bits is 0. The processing unit is further configured to decode the codeword, to obtain the information bits.

In a possible design, if $n_2$ is less than 324, and the codeword includes the information bits and first check bits, that the processing unit is configured to decode the codeword, to obtain the information bits includes: The processing unit is configured to decode the codeword by using an LDPC matrix with a coding rate of 5/6, to obtain the information bits.

If $n_2$ is greater than or equal to 324, and the codeword includes the information bits, first check bits, and second check bits, that the processing unit is configured to decode the codeword, to obtain the information bits includes: The processing unit is configured to decode the codeword by using an LDGM matrix, to obtain a first codeword, where the first codeword includes the information bits and the first check bits. The processing unit is further configured to decode the first codeword by using an LDPC matrix with a coding rate of 5/6, to obtain the information bits.

All related content of the steps in the foregoing method embodiments may be referenced to function descriptions of a corresponding function module, and details are not described herein again.

In this embodiment, the sending apparatus 190 or the receiving apparatus 200 is presented with the function modules implemented through integration. The "unit" herein may be an application-specific integrated circuit (application specific integrated circuit, ASIC), a processor for executing one or more software or firmware programs, a memory, an integrated logical circuit, and/or another component that can provide the foregoing function. In a simple embodiment, a person skilled in the art may think that the sending apparatus 190 or the receiving apparatus 200 may use the form of the communication device 2100 shown in FIG. 21.

For example, the processor 2101 in the communication device 2100 shown in FIG. 21 enables, by invoking computer-executable instructions stored in a memory 2103, the communication device 2100 to perform the encoding and decoding method in the foregoing method embodiments.

Specifically, functions/implementation processes of the processing unit 1901 in FIG. 19 may be implemented by the processor 2101 in the communication device 2100 shown in FIG. 21 by invoking the computer-executable instructions stored in the memory 2103. Alternatively, functions/implementation processes of the sending unit 1902 in FIG. 19 may be implemented by the communication interface 2104 in the communication device 2100 shown in FIG. 21.

Specifically, functions/implementation processes of the processing unit 2001 in FIG. 20 may be implemented by the processor 2101 in the communication device 2100 shown in FIG. 21 by invoking the computer-executable instructions stored in the memory 2103. Alternatively, functions/implementation processes of the sending unit 2002 in FIG. 20 may be implemented by the communication interface 2104 in the communication device 2100 shown in FIG. 21.

The sending apparatus 190 provided in this embodiment may perform the foregoing encoding method. Therefore, for technical effects that can be achieved by the sending apparatus 190, refer to the foregoing method embodiments. Details are not described herein again. The receiving apparatus 200 provided in this embodiment may perform the foregoing decoding method. Therefore, for technical effects that can be achieved by the receiving apparatus 200, refer to the foregoing method embodiments. Details are not described herein again.

It should be noted that one or more of the foregoing modules or units may be implemented by using software, hardware, or a combination thereof. When any one of the foregoing modules or units is implemented by using software, the software exists in a form of computer program instructions, and is stored in a memory. A processor may be configured to execute the program instructions to implement the foregoing method procedures. The processor may be built into a SoC (system-on-a-chip) or an ASIC, or may be an independent semiconductor chip. The processor includes a core for executing software instructions to perform operations or processing, and may further include a necessary hardware accelerator, for example, a field programmable gate array (field programmable gate array, FPGA), a PLD (programmable logic device), or a logic circuit that implements a special-purpose logic operation.

When the foregoing modules or units are implemented by using hardware, the hardware may be any one or any combination of a CPU, a microprocessor, a digital signal processing (digital signal processing, DSP) chip, a microcontroller unit (microcontroller unit, MCU), an artificial intelligence processor, an ASIC, a SoC, an FPGA, a PLD, a dedicated digital circuit, a hardware accelerator, or a non-integrated discrete device, and the hardware may run necessary software or does not depend on software to perform the foregoing method procedures.

Optionally, an embodiment of this application further provides a sending apparatus (where for example, the sending apparatus may be a chip or a chip system). The sending apparatus includes a processor, configured to implement the encoding method according to any one of the foregoing method embodiments. In a possible design, the sending apparatus further includes a memory. The memory is configured to store necessary program instructions and data. The processor may invoke program code stored in the memory, to indicate the sending apparatus to perform the encoding method according to any one of the foregoing method embodiments. Certainly, the memory may alternatively not be located in the sending apparatus. When the sending apparatus is a chip system, the sending apparatus may include a chip, or may include a chip and another discrete device. This is not specifically limited in this embodiment of this application.

Optionally, an embodiment of this application further provides a receiving apparatus (where for example, the receiving apparatus may be a chip or a chip system). The receiving apparatus includes a processor, configured to implement the decoding method according to any one of the foregoing method embodiments. In a possible design, the receiving apparatus further includes a memory. The memory is configured to store necessary program instructions and data. The processor may invoke program code stored in the memory, to indicate the receiving apparatus to perform the decoding method according to any one of the foregoing method embodiments. Certainly, the memory may alternatively not be located in the receiving apparatus. When the receiving apparatus is a chip system, the receiving apparatus may include a chip, or may include a chip and another discrete device. This is not specifically limited in this embodiment of this application.

All or a part of the foregoing embodiments may be implemented by using software, hardware, firmware, or any combination thereof. When a software program is used to implement embodiments, all or a part of embodiments may be implemented in a form of a computer program product. The computer program product includes one or more computer instructions. When the computer program instructions are loaded and executed on a computer, all or a part of the procedures or functions according to embodiments of this application are generated. The computer may be a general-purpose computer, a dedicated computer, a computer network, or other programmable apparatuses. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible to a computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid-state drive (solid state disk, SSD)), or the like.

Although this application is described with reference to embodiments, its scope of protection is defined by the accompanying claims. In the claims, "comprising" (comprising) does not exclude another component or another step, and "a" or "one" does not exclude a case of multiple. A single processor or another unit may implement several functions listed in the claims. Some measures are recorded in dependent claims that are different from each other, but this does not mean that these measures cannot be combined to produce a better effect, according to the claim dependencies.

## Claims

1. A sending apparatus (190), comprising a processing unit (1901, 2001) and a sending unit (1902), wherein

    the processing unit (1901, 2001) is configured to determine a first low-density parity-check LDPC matrix based on a quantity $n_1$ of first transmission bits;
    the processing unit (1901, 2001) is further configured to encode information bits based on the first LDPC matrix, to obtain the first transmission bits; and
    the sending unit (1902) is configured to send the first transmission bits; wherein the quantity $n_1$ of the first transmission bits has a correspondence with a coding rate of the first LDPC matrix,
    **characterised in that**:
    if $n_1$ is less than No, the coding rate of the first LDPC matrix is 5/6;
    if $n_1$ is greater than or equal to N0 and less than N1, the coding rate of the first LDPC matrix is 5/6;
    if $n_1$ is greater than or equal to N1 and less than N2, the coding rate of the first LDPC matrix is 3/4;

    if $n_1$ is greater than or equal to N2 and less than N3, the coding rate of the first LDPC matrix is 2/3;
    if $n_1$ is greater than or equal to N3 and less than or equal to N4, the coding rate of the first LDPC matrix is 1/2; or
    if $n_1$ is greater than N4, the coding rate of the first LDPC matrix is 1/2; wherein
    N0 is 324; N1 is 468; N2 is 648; N3 is 972; and N4 is 1932.

2. The sending apparatus (190) according to claim 1, wherein that the processing unit (1901, 2001) is further configured to encode information bits based on the first LDPC matrix, to obtain the first transmission bits comprises:

    the processing unit (1901, 2001) is configured to encode the information bits based on the first LDPC matrix, to obtain a first codeword, wherein the first codeword comprises the information bits and m check bits; and
    the processing unit (1901, 2001) is configured to determine the first transmission bits from the first codeword based on the quantity $n_1$ of the first transmission bits.

3. The sending apparatus (190) according to claim 2, wherein the first transmission bits comprise a part of the m check bits, the first transmission bits comprise the m check bits, the first transmission bits comprise the m check bits and a part of the information bits, or the first transmission bits comprise the first codeword; or
    the quantity of the first transmission bits is zero.

4. The sending apparatus (190) according to claim 2 or 3, wherein

    if $n_1$ is less than No, the first transmission bits comprise the first $n_1$ bits in the m check bits;
    if $n_1$ is greater than or equal to N0 and less than N1, the first transmission bits comprise the m check bits and the first ($n_1$ -m) bits in the information bits;
    if $n_1$ is greater than or equal to N1 and less than N2, the first transmission bits comprise the m check bits and the first ($n_1$ -m) bits in the information bits;
    if $n_1$ is greater than or equal to N2 and less than N3, the first transmission bits comprise the m check bits and the first ($n_1$ -m) bits in the information bits;
    if $n_1$ is greater than or equal to N3 and less than or equal to N4, the first transmission bits comprise the m check bits and the first ($n_1$ -m) bits in the information bits; or
    if $n_1$ is greater than N4, the first transmission bits comprise the information bits and the m check bits.

5. The sending apparatus (190) according to any one of claims 1 to 4, wherein the quantity $n_1$ of the first transmission bits is a value determined based on priorities of the information bits, and the information bits are one of N layers of bit sequences obtained by layering original information.

6. The sending apparatus (190) according to claim 5, wherein the original information comprises a plurality of bits, and the layering comprises: the processing unit (1901, 2001) is configured to layer the plurality of bits into the N layers of bit sequences based on priorities of bits in the original information.

7. A receiving apparatus (200), comprising a processing unit (1901, 2001) and a receiving unit (2002), wherein

the receiving unit (2002) is configured to receive first transmission bits;
the processing unit (1901, 2001) is configured to determine a first low-density parity-check LDPC matrix based on a quantity $n_1$ of the first transmission bits; and
the processing unit (1901, 2001) is further configured to decode the first transmission bits based on the first LDPC matrix, to obtain information bits; wherein the quantity $n_1$ of the first transmission bits has a correspondence with a coding rate of the first LDPC matrix, **characterised in that**:

if $n_1$ is less than No, the coding rate of the first LDPC matrix is 5/6;
if $n_1$ is greater than or equal to N0 and less than N1, the coding rate of the first LDPC matrix is 5/6;
if $n_1$ is greater than or equal to N1 and less than N2, the coding rate of the first LDPC matrix is 3/4;
if $n_1$ is greater than or equal to N2 and less than N3, the coding rate of the first LDPC matrix is 2/3;
if $n_1$ is greater than or equal to N3 and less than or equal to N4, the coding rate of the first LDPC matrix is 1/2; or
if $n_1$ is greater than N4, the coding rate of the first LDPC matrix is 1/2; wherein
N0 is 324; N1 is 468; N2 is 648; N3 is 972; and N4 is 1932.

8. The receiving apparatus (200) according to claim 7, wherein that the processing unit (1901, 2001) is configured to decode the first transmission bits based on the first LDPC matrix, to obtain information bits comprises:

the processing unit (1901, 2001) is configured to obtain a first codeword based on the first transmission bits and the first low-density parity-check LDPC matrix corresponding to the quantity $n_1$ of the first transmission bits, wherein the first codeword comprises the first transmission bits and other bits, the other bits comprise other information bits and other check bits, an LLR value of the other information bits in the other bits is a first LLR value, and an LLR value of the other check bits in the other bits is 0; and
the processing unit (1901, 2001) is configured to decode the first codeword by using the first LDPC matrix, to obtain the information bits.

9. The receiving apparatus (200) according to claim 8, wherein the first LLR value is a value determined based on information about a ratio of 0s or 1s in the information bits.

10. An encoding method, comprising:

determining, by a sending apparatus (190), a first low-density parity-check LDPC matrix based on a quantity $n_1$ of first transmission bits;
encoding, by the sending apparatus (190), information bits based on the first LDPC matrix, to obtain the first transmission bits; and
sending, by the sending apparatus (190), the first transmission bits; wherein the quantity $n_1$ of the first transmission bits has a correspondence with a coding rate of the first LDPC matrix, **characterised in that**:

if $n_1$ is less than N0, the coding rate of the first LDPC matrix is 5/6;
if $n_1$ is greater than or equal to N0 and less than N1, the coding rate of the first LDPC matrix is 5/6;
if $n_1$ is greater than or equal to N1 and less than N2, the coding rate of the first LDPC matrix is 3/4;
if $n_1$ is greater than or equal to N2 and less than N3, the coding rate of the first LDPC matrix is 2/3;
if $n_1$ is greater than or equal to N3 and less than or equal to N4, the coding rate of the first LDPC matrix is 1/2; or
if $n_1$ is greater than N4, the coding rate of the first LDPC matrix is 1/2; wherein
N0 is 324; N1 is 468; N2 is 648; N3 is 972; and N4 is 1932.

**Patentansprüche**

1. Sendeeinrichtung (190), die eine Verarbeitungseinheit (1901, 2001) und eine Sendeeinheit (1902) umfasst, wobei

   die Verarbeitungseinheit (1901, 2001) konfiguriert ist, um eine erste Low-Density-Parity-Check(LDPC)-Matrix basierend auf einer Menge $n_1$ der ersten Übertragungsbits zu bestimmen;
   die Verarbeitungseinheit (1901, 2001) ferner konfiguriert ist, um Informationsbits basierend auf der ersten LDPC-Matrix zu codieren, um die ersten Übertragungsbits zu erhalten; und
   die Sendeeinheit (1902) konfiguriert ist, um die ersten Übertragungsbits zu senden; wobei die Menge $n_1$ der ersten Übertragungsbits eine Entsprechung mit einer Codierrate der ersten LDPC-Matrix aufweist, **dadurch gekennzeichnet, dass**:

   falls $n_1$ kleiner als N0 ist, die Codierrate der ersten LDPC-Matrix 5/6 beträgt;
   falls $n_1$ größer als oder gleich N0 und kleiner als N1 ist, die Codierrate der ersten LDPC-Matrix 5/6 beträgt;
   falls $n_1$ größer als oder gleich N1 und kleiner als N2 ist, die Codierrate der ersten LDPC-Matrix 3/4 beträgt;
   falls $n_1$ größer als oder gleich N2 und kleiner als N3 ist, die Codierrate der ersten LDPC-Matrix 2/3 beträgt;
   falls $n_1$ größer als oder gleich N3 und kleiner als oder gleich N4 ist, die Codierrate der ersten LDPC-Matrix 1/2 beträgt; oder
   falls $n_1$ größer als N4 ist, die Codierrate der ersten LDPC-Matrix 1/2 beträgt; wobei N0 324 ist; N1 468 ist; N2 648 ist; N3 972 ist; und N4 1932 ist.

2. Sendeeinrichtung (190) nach Anspruch 1, wobei, dass die Verarbeitungseinheit (1901, 2001) ferner konfiguriert ist, um Informationsbits basierend auf der ersten LDPC-Matrix zu codieren, um die ersten Übertragungsbits zu erhalten, umfasst:

   die Verarbeitungseinheit (1901, 2001) ist konfiguriert, um die Informationsbits basierend auf der ersten LDPC-Matrix zu codieren, um ein erstes Codewort zu erhalten, wobei das erste Codewort die Informationsbits und m Prüfbits umfasst; und
   die Verarbeitungseinheit (1901, 2001) konfiguriert ist, um die ersten Übertragungsbits von dem ersten Codewort basierend auf der Menge $n_1$ der ersten Übertragungsbits zu bestimmen.

3. Sendeeinrichtung (190) nach Anspruch 2, wobei die ersten Übertragungsbits einen Teil der m Prüfbits umfassen, die ersten Übertragungsbits die m Prüfbits umfassen, die ersten Übertragungsbits die m Prüfbits und einen Teil der Informationsbits umfassen oder die ersten Übertragungsbits das erste Codewort umfassen; oder
   die Menge der ersten Übertragungsbits null ist.

4. Sendeeinrichtung (190) nach Anspruch 2 oder 3, wobei

   falls $n_1$ kleiner als N0 ist, die ersten Übertragungsbits die ersten $n_1$ Bits in den m Prüfbits umfassen;
   falls $n_1$ größer als oder gleich N0 und kleiner als N1 ist, die ersten Übertragungsbits die m Prüfbits und die ersten $(n_1\text{-}m)$ Bits in den Informationsbits umfassen;
   falls $n_1$ größer als oder gleich N1 und kleiner als N2 ist, die ersten Übertragungsbits die m Prüfbits und die ersten $(n_1\text{-}m)$ Bits in den Informationsbits umfassen;
   falls $n_1$ größer als oder gleich N2 und kleiner als N3 ist, die ersten Übertragungsbits die m Prüfbits und die ersten $(n_1\text{-}m)$ Bits in den Informationsbits umfassen;
   falls $n_1$ größer als oder gleich N3 und kleiner als oder gleich N4 ist, die ersten Übertragungsbits die m Prüfbits und die ersten $(n_1\text{-}m)$ Bits in den Informationsbits umfassen; oder
   falls $n_1$ größer als N4 ist, die ersten Übertragungsbits die Informationsbits und die m Prüfbits umfassen.

5. Sendeeinrichtung (190) nach einem der Ansprüche 1 bis 4, wobei die Menge $n_1$ der ersten Übertragungsbits ein Wert, der basierend auf Prioritäten der Informationsbits bestimmt wird, ist und die Informationsbits eine von N Schichten von Bitsequenzen, die durch Schichten von Originalinformationen erhalten werden, sind.

6. Sendeeinrichtung (190) nach Anspruch 5, wobei die Originalinformationen eine Vielzahl von Bits umfassen und das Schichten umfasst: die Verarbeitungseinheit (1901, 2001) ist konfiguriert, um die Vielzahl von Bits in die N Schichten von Bitsequenzen basierend auf Prioritäten von Bits in den Originalinformationen zu schichten.

7. Empfangseinrichtung (200), die eine Verarbeitungseinheit (1901, 2001) und eine Empfangseinheit (2002) umfasst, wobei

   die Empfangseinheit (2002) konfiguriert ist, um die ersten Übertragungsbits zu empfangen;
   die Verarbeitungseinheit (1901, 2001) konfiguriert ist, um eine erste Low-Density-Parity-Check(LDPC)-Matrix basierend auf einer Menge $n_1$ der ersten Übertragungsbits zu bestimmen; und

die Verarbeitungseinheit (1901, 2001) ferner konfiguriert ist, um die ersten Übertragungsbits basierend auf der ersten LDPC-Matrix zu decodieren, um Informationsbits zu erhalten; wobei die Menge $n_1$ der ersten Übertragungsbits eine Entsprechung mit einer Codierrate der ersten LDPC-Matrix aufweist, **dadurch gekennzeichnet, dass**:

falls $n_1$ kleiner als N0 ist, die Codierrate der ersten LDPC-Matrix 5/6 beträgt;
falls $n_1$ größer als oder gleich N0 und kleiner als N1 ist, die Codierrate der ersten LDPC-Matrix 5/6 beträgt;
falls $n_1$ größer als oder gleich N1 und kleiner als N2 ist, die Codierrate der ersten LDPC-Matrix 3/4 beträgt;
falls $n_1$ größer als oder gleich N2 und kleiner als N3 ist, die Codierrate der ersten LDPC-Matrix 2/3 beträgt;
falls $n_1$ größer als oder gleich N3 und kleiner als oder gleich N4 ist, die Codierrate der ersten LDPC-Matrix 1/2 beträgt; oder
falls $n_1$ größer als N4 ist, die Codierrate der ersten LDPC-Matrix 1/2 beträgt; wobei N0 324 ist; N1 468 ist; N2 648 ist; N3 972 ist; und N4 1932 ist.

8. Empfangseinrichtung (200) nach Anspruch 7, wobei, dass die Verarbeitungseinheit (1901, 2001) konfiguriert ist, um die ersten Übertragungsbits basierend auf der ersten LDPC-Matrix zu decodieren, um Informationsbits zu erhalten, umfasst:

die Verarbeitungseinheit (1901, 2001) ist konfiguriert, um ein erstes Codewort basierend auf den ersten Übertragungsbits und der ersten Low-Density-Parity-Check(LDPC)-Matrix, die der Menge $n_1$ der ersten Übertragungsbits entspricht, zu erhalten, wobei das erste Codewort die ersten Übertragungsbits und andere Bits umfasst, die anderen Bits andere Informationsbits und andere Prüfbits umfassen, ein LLR-Wert der anderen Informationsbits in den anderen Bits ein erster LLR-Wert ist und ein LLR-Wert der anderen Prüfbits in den anderen Bits 0 ist; und
die Verarbeitungseinheit (1901, 2001) ist konfiguriert, um das erste Codewort durch Verwenden der ersten LDPC-Matrix zu decodieren, um die Informationsbits zu erhalten.

9. Empfangseinrichtung (200) nach Anspruch 8, wobei der erste LLR-Wert ein Wert, der basierend auf Informationen über ein Verhältnis von 0en oder 1en in den Informationsbits bestimmt wird, ist.

10. Codierungsverfahren, das umfasst:

Bestimmen, durch eine Sendeeinrichtung (190), einer ersten Low-Density-Parity-Check(LDPC)-Matrix basierend auf einer Menge $n_1$ der ersten Übertragungsbits;
Codieren, durch die Sendeeinrichtung (190), von Informationsbits basierend auf der ersten LDPC-Matrix, um die ersten Übertragungsbits zu erhalten; und
Senden, durch die Sendeeinrichtung (190), der ersten Übertragungsbits; wobei die Menge $n_1$ der ersten Übertragungsbits eine Entsprechung mit einer Codierrate der ersten LDPC-Matrix aufweist, **dadurch gekennzeichnet, dass**:

falls $n_1$ kleiner als N0 ist, die Codierrate der ersten LDPC-Matrix 5/6 beträgt;
falls $n_1$ größer als oder gleich N0 und kleiner als N1 ist, die Codierrate der ersten LDPC-Matrix 5/6 beträgt;
falls $n_1$ größer als oder gleich N1 und kleiner als N2 ist, die Codierrate der ersten LDPC-Matrix 3/4 beträgt;
falls $n_1$ größer als oder gleich N2 und kleiner als N3 ist, die Codierrate der ersten LDPC-Matrix 2/3 beträgt;
falls $n_1$ größer als oder gleich N3 und kleiner als oder gleich N4 ist, die Codierrate der ersten LDPC-Matrix 1/2 beträgt; oder
falls $n_1$ größer als N4 ist, die Codierrate der ersten LDPC-Matrix 1/2 beträgt; wobei N0 324 ist; N1 468 ist; N2 648 ist; N3 972 ist; und N4 1932 ist.

**Revendications**

1. Appareil d'envoi (190), comprenant une unité de traitement (1901, 2001) et une unité d'envoi (1902), dans lequel

l'unité de traitement (1901, 2001) est configurée pour déterminer une première matrice de contrôle de parité à faible densité LDPC sur la base d'une quantité $n_1$ de premiers bits de transmission ;
l'unité de traitement (1901, 2001) est en outre configurée pour coder des bits d'information sur la base de la première matrice LDPC, afin d'obtenir les premiers bits de transmission ; et
l'unité d'envoi (1902) est configurée pour envoyer les premiers bits de transmission ; dans lequel la quantité $n_1$ des premiers bits de transmission a une correspondance avec un taux de codage de la première matrice LDPC, **caractérisé en ce que** :

si $n_1$ est inférieur à N0, le taux de codage de la première matrice LDPC est de 5/6 ;
si $n_1$ est supérieur ou égal à N0 et inférieur à N1, le taux de codage de la première matrice LDPC est de 5/6 ;
si $n_1$ est supérieur ou égal à N1 et inférieur à N2, le taux de codage de la première matrice LDPC est de 3/4 ;
si $n_1$ est supérieur ou égal à N2 et inférieur à N3, le taux de codage de la première matrice LDPC est de 2/3 ;
si $n_1$ est supérieur ou égal à N3 et inférieur ou égal à N4, le taux de codage de la première matrice LDPC est de 1/2 ; ou
si $n_1$ est supérieur à N4, le taux de codage de la première matrice LDPC est de 1/2 ; où N0 est 324 ; N1 est 468 ; N2 est 648 ; N3 est 972 ; et N4 est 1932.

2. Appareil d'envoi (190) selon la revendication 1, dans lequel le fait que l'unité de traitement (1901, 2001) est en outre configurée pour coder des bits d'information sur la base de la première matrice LDPC, afin d'obtenir les premiers bits de transmission, comprend :

l'unité de traitement (1901, 2001) est configurée pour coder les bits d'information sur la base de la première matrice LDPC, afin d'obtenir un premier mot codé, dans lequel le premier mot codé comprend les bits d'information et m bits de contrôle ; et
l'unité de traitement (1901, 2001) est configurée pour déterminer les premiers bits de transmission à partir du premier mot codé sur la base de la quantité $n_1$ des premiers bits de transmission.

3. Appareil d'envoi (190) selon la revendication 2, dans lequel les premiers bits de transmission comprennent une partie des m bits de contrôle, les premiers bits de transmission comprennent les m bits de contrôle, les premiers bits de transmission comprennent les m bits de contrôle et une partie des bits d'information, ou les premiers bits de transmission comprennent le premier mot codé ; ou la quantité des premiers bits de transmission est nulle.

4. Appareil d'envoi (190) selon la revendication 2 ou 3, dans lequel

si $n_1$ est inférieur à N0, les premiers bits de transmission comprennent les $n_1$ premiers bits des m bits de contrôle ;
si $n_1$ est supérieur ou égal à N0 et inférieur à N1, les premiers bits de transmission comprennent les m bits de contrôle et les premiers ($n_1$ - m) bits dans les bits d'information ; si $n_1$ est supérieur ou égal à N1 et inférieur à N2, les premiers bits de transmission comprennent les m bits de contrôle et les premiers ($n_1$ - m) bits dans les bits d'information ; si $n_1$ est supérieur ou égal à N2 et inférieur à N3, les premiers bits de transmission comprennent les m bits de contrôle et les premiers ($n_1$ - m) bits dans les bits d'information ; si $n_1$ est supérieur ou égal à N3 et inférieur ou égal à N4, les premiers bits de transmission comprennent les m bits de contrôle et les premiers ($n_1$ - m) bits dans les bits d'information ; ou si $n_1$ est supérieur à N4, les premiers bits de transmission comprennent les bits d'information et les m bits de contrôle.

5. Appareil d'envoi (190) selon l'une quelconque des revendications 1 à 4, dans lequel la quantité $n_1$ des premiers bits de transmission est une valeur déterminée sur la base de priorités des bits d'information, et les bits d'information sont l'une de N couches de séquences de bits obtenues par une mise en couche d'information originale.

6. Appareil d'envoi (190) selon la revendication 5, dans lequel l'information originale comprend une pluralité de bits, et la mise en couche comprend : l'unité de traitement (1901, 2001) est configurée pour mettre en couche la pluralité de bits dans les N couches de séquences de bits sur la base de priorités de bits dans l'information originale.

7. Appareil d'envoi (200), comprenant une unité de traitement (1901, 2001) et une unité de réception (2002), dans lequel

l'unité de réception (2002) est configurée pour recevoir des premiers bits de transmission ; l'unité de traitement (1901, 2001) est configurée pour déterminer une première matrice de contrôle de parité à faible densité LDPC sur la base d'une quantité $n_1$ des premiers bits de transmission ; et
l'unité de traitement (1901, 2001) est en outre configurée pour décoder les premiers bits de transmission sur la base de la première matrice LDPC, afin d'obtenir des bits d'information ; dans lequel la quantité $n_1$ des premiers bits de transmission a une correspondance avec un taux de codage de la première matrice LDPC, **caractérisé en ce que :**

si $n_1$ est inférieur à N0, le taux de codage de la première matrice LDPC est de 5/6 ;
si $n_1$ est supérieur ou égal à N0 et inférieur à N1, le taux de codage de la première matrice LDPC est de 5/6 ;
si $n_1$ est supérieur ou égal à N1 et inférieur à N2, le taux de codage de la première matrice LDPC est de 3/4 ;
si $n_1$ est supérieur ou égal à N2 et inférieur à N3, le taux de codage de la première matrice LDPC est de 2/3 ;
si $n_1$ est supérieur ou égal à N3 et inférieur ou égal à N4, le taux de codage de la première matrice LDPC est de 1/2 ; ou
si $n_1$ est supérieur à N4, le taux de codage de la première matrice LDPC est de 1/2 ; où N0 est 324 ; N1 est 468 ; N2 est 648 ; N3 est 972 ; et N4 est 1932.

8. Appareil de réception (200) selon la revendication 7, dans lequel le fait que l'unité de traitement (1901, 2001) est configurée pour décoder les premiers bits de transmission sur la base de la première matrice LDPC, afin d'obtenir des bits d'information, comprend :

l'unité de traitement (1901, 2001) est configurée pour obtenir un premier mot codé sur la base des premiers bits de transmission et de la première matrice de contrôle de parité à faible densité LDPC correspondant à la quantité $n_1$ des premiers bits de transmission, dans lequel le premier mot codé comprend les premiers bits de transmission et d'autres bits, les autres bits comprennent d'autres bits d'information et d'autres bits de contrôle, une valeur LLR des autres bits d'information dans les autres bits est une première valeur LLR, et une valeur LLR des autres bits de contrôle dans les autres bits est de 0 ; et
l'unité de traitement (1901, 2001) est configurée pour décoder le premier mot codé à l'aide de la première matrice LDPC, afin d'obtenir les bits d'information.

9. Appareil de réception (200) selon la revendication 8, dans lequel la première valeur LLR est une valeur déterminée sur la base d'information concernant un rapport de 0 ou de 1 dans les bits d'information.

10. Procédé de codage, comprenant :

la détermination, par un appareil d'envoi (190), d'une première matrice de contrôle de parité à faible densité LDPC sur la base d'une quantité $n_1$ de premiers bits de transmission ;
le codage, par l'appareil d'envoi (190), de bits d'information sur la base de la première matrice LDPC, afin d'obtenir les premiers bits de transmission ; et
l'envoi, par l'appareil d'envoi (190), des premiers bits de transmission ; dans lequel la quan-

tité $n_1$ des premiers bits de transmission a une correspondance avec un taux de codage de la première matrice LDPC, **caractérisé en ce que** :

si $n_1$ est inférieur à N0, le taux de codage de la première matrice LDPC est de 5/6 ;
si $n_1$ est supérieur ou égal à N0 et inférieur à N1, le taux de codage de la première matrice LDPC est de 5/6 ;
si $n_1$ est supérieur ou égal à N1 et inférieur à N2, le taux de codage de la première matrice LDPC est de 3/4 ;
si $n_1$ est supérieur ou égal à N2 et inférieur à N3, le taux de codage de la première matrice LDPC est de 2/3 ;
si $n_1$ est supérieur ou égal à N3 et inférieur ou égal à N4, le taux de codage de la première matrice LDPC est de 1/2 ; ou
si $n_1$ est supérieur à N4, le taux de codage de la première matrice LDPC est de 1/2 ; où N0 est 324 ; N1 est 468 ; N2 est 648 ; N3 est 972 ; et N4 est 1932.

FIG. 1

```
R = 1/2.
57  -   -   -  50   -  11   -  50   -  79   -   1   0   -   -   -   -   -   -   -   -   -   -
 3  -  28   -   0   -   -   -  55   7   -   -   -   0   0   -   -   -   -   -   -   -   -   -
30  -   -   -  24  37   -   -  56  14   -   -   -   -   0   0   -   -   -   -   -   -   -   -
62 53   -   -  53   -   -   3  35   -   -   -   -   -   -   0   0   -   -   -   -   -   -   -
40  -   -  20  66   -   -  22  28   -   -   -   -   -   -   -   0   0   -   -   -   -   -   -
 0  -   -   -   8   -  42   -  50   -   -   8   -   -   -   -   -   0   0   -   -   -   -   -
69 79  79   -   -   -  56   -  52   -   -   -   0   -   -   -   -   -   0   0   -   -   -   -
65  -   -   -  38  57   -   -  72   -  27   -   -   -   -   -   -   -   -   0   0   -   -   -
64  -   -   -  14  52   -   -  30   -   -  32   -   -   -   -   -   -   -   -   0   0   -   -
 -  45   -  70   0   -   -   -  77   9   -   -   -   -   -   -   -   -   -   -   -   0   0   -
 2  56   -  57  35   -   -   -   -   -  12   -   -   -   -   -   -   -   -   -   -   -   0   0
24  -  61   -  60   -   -  27  51   -   -  16   1   -   -   -   -   -   -   -   -   -   -   0
```

```
R = 2/3.
61 75   4  63  56   -   -   -   -   -   -   8   -   2  17  25   1   0   -   -   -   -   -   -
56 74  77  20   -   -   -  64  24   4  67   -   7   -   -   -   -   0   0   -   -   -   -   -
28 21  68  10   7  14  65   -   -   -  23   -   -   -  75   -   -   -   0   0   -   -   -   -
48 38  43  78  76   -   -   -   -   5  36   -  15  72   -   -   -   -   -   0   0   -   -   -
40  2  53  25   -  52  62   -  20   -   -  44   -   -   -   -   0   -   -   -   0   0   -   -
69 23  64  10  22   -  21   -   -   -   -   -  68  23  29   -   -   -   -   -   -   0   0   -
12  0  68  20  55  61   -  40   -   -   -  52   -   -   -  44   -   -   -   -   -   -   0   0
58  8  34  64  78   -   -  11  78  24   -   -   -   -   -  58   1   -   -   -   -   -   -   0
```

```
R = 3/4.
48 29  28  39   9  61   -   -   -  63  45  80   -   -   -  37  32  22   1   0   -   -   -   -
 4 49  42  48  11  30   -   -   -  49  17  41  37  15   -  54   -   -   -   0   0   -   -   -
35 76  78  51  37  35  21   -  17  64   -   -   -  59   7   -   -  32   -   -   0   0   -   -
 9 65  44   9  54  56  73  34  42   -   -   -  35   -   -   -  46  39   0   -   -   0   0   -
 3 62   7  80  68  26   -  80  55   -  36   -  26   -   9   -  72   -   -   -   -   -   0   0
26 75  33  21  69  59   3  38   -   -   -  35   -  62  36  26   -   -   1   -   -   -   -   0
```

```
R = 5/6.
13 48  80  66   4  74   7  30  76  52  37  60   -  49  73  31  74  73  23   -   1   0   -   -
69 63  74  56  64  77  57  65   6  16  51   -  64   -  68   9  48  62  54  27   -   0   0   -
51 15   0  80  24  25  42  54  44  71  71   9  67  35   -  58   -  29   -  53   0   -   0   0
16 29  36  41  44  56  59  37  50  24   -  65   4  65  52   -   4   -  73  52   1   -   -   0
```

FIG. 2

24

FIG. 3

FIG. 4

EP 4 047 846 B1

FIG. 5

```
┌─────────────────────────┐                    ┌─────────────────────────┐
│   Sending apparatus     │                    │  Receiving apparatus    │
└─────────────────────────┘                    └─────────────────────────┘
             │                                              │
┌─────────────────────────┐                                │
│ S600: Obtain information│                                 │
│  bits and a quantity of │                                 │
│  first transmission bits│                                 │
└─────────────────────────┘                                │
             │                                              │
┌─────────────────────────┐                                │
│ S601: Determine a first │                                 │
│ LDPC matrix based on the│                                 │
│ quantity of the first   │                                 │
│ transmission bits       │                                 │
└─────────────────────────┘                                │
             │                                              │
┌─────────────────────────┐                                │
│ S602: Encode the        │                                 │
│ information bits based on│                                │
│ the first LDPC matrix, to│                                │
│ obtain the first         │                                │
│ transmission bits        │                                │
└─────────────────────────┘                                │
             │         S603: First transmission bits        │
             │────────────────────────────────────────────▶│
             │                                              │
             │                       ┌──────────────────────────────────┐
             │                       │ S604: Determine the first LDPC    │
             │                       │ matrix based on the quantity of   │
             │                       │ the first transmission bits       │
             │                       └──────────────────────────────────┘
             │                                              │
             │                       ┌──────────────────────────────────┐
             │                       │ S605: Decode the first            │
             │                       │ transmission bits based on the    │
             │                       │ first LDPC matrix, to obtain the  │
             │                       │ information bits                  │
             │                       └──────────────────────────────────┘
             │                                              │
```

FIG. 6

FIG. 7

```
┌─────────────────────────┐              ┌─────────────────────────┐
│   Sending apparatus     │              │   Receiving apparatus   │
└─────────────────────────┘              └─────────────────────────┘
            │                                        │
┌─────────────────────────┐                          │
│ S600: Obtain information │                          │
│ bits and a quantity of  │                          │
│ first transmission bits │                          │
└─────────────────────────┘                          │
            │                                        │
┌─────────────────────────┐                          │
│ S601: Determine a first │                          │
│ LDPC matrix based on    │                          │
│ the quantity of the     │                          │
│ first transmission bits │                          │
└─────────────────────────┘                          │
            │                                        │
┌─────────────────────────┐                          │
│ S6021: Encode the       │                          │
│ information bits based   │                          │
│ on the first LDPC       │                          │
│ matrix, to obtain a     │                          │
│ first codeword          │                          │
└─────────────────────────┘                          │
            │                                        │
┌─────────────────────────┐                          │
│ S6022: Determine the    │                          │
│ first transmission bits  │                          │
│ from the first codeword  │                          │
│ based on the quantity    │                          │
│ of the first             │                          │
│ transmission bits        │                          │
└─────────────────────────┘                          │
            │   S603: First transmission bits         │
            │───────────────────────────────────────▶│
            │                                        │
            │              ┌─────────────────────────┐
            │              │ S604: Determine the     │
            │              │ first LDPC matrix based  │
            │              │ on the quantity of the   │
            │              │ first transmission bits  │
            │              └─────────────────────────┘
            │                                        │
            │              ┌─────────────────────────┐
            │              │ S6051: Obtain the first  │
            │              │ codeword based on the    │
            │              │ first transmission bits  │
            │              │ and the first LDPC       │
            │              │ matrix corresponding to  │
            │              │ the quantity of the      │
            │              │ first transmission bits  │
            │              └─────────────────────────┘
            │                                        │
            │              ┌─────────────────────────┐
            │              │ S6052: Decode the first  │
            │              │ codeword based on the    │
            │              │ first LDPC matrix, to    │
            │              │ obtain the information   │
            │              │ bits                     │
            │              └─────────────────────────┘
            │                                        │
```

FIG. 8

First
transmission
bits

Information bits  Shortened all-zero bits  Check bits

FIG. 9(a)

First
transmission
bits

First transmission bits

Information bits  Shortened all-
zero bits  Check bits

FIG. 9(b)

```
┌─────────────────────┐                              ┌──────────────────────┐
│  Sending apparatus  │                              │ Receiving apparatus  │
└─────────────────────┘                              └──────────────────────┘
          │                                                      │
┌──────────────────────────────────┐                            │
│ S1000: Obtain information bits    │                            │
│ and a quantity of second          │                            │
│ transmission bits                 │                            │
└──────────────────────────────────┘                            │
          │                                                      │
┌──────────────────────────────────┐                            │
│ S1001: Process the information    │                            │
│ bits based on the quantity of the │                            │
│ second transmission bits, to      │                            │
│ obtain the second transmission    │                            │
│ bits                              │                            │
└──────────────────────────────────┘                            │
          │       S1002: Second transmission bits                │
          │ ────────────────────────────────────────────────▶   │
          │                                                      │
          │                         ┌────────────────────────────────────────┐
          │                         │ S1003: Process the second transmission  │
          │                         │ bits based on the quantity of the second│
          │                         │ transmission bits, to obtain the        │
          │                         │ information bits                        │
          │                         └────────────────────────────────────────┘
          │                                                      │
```

FIG. 10

FIG. 11

32

Quantity of second
transmission bits

Zero matrix

LDPC matrix

Identity matrix

LDGM part

FIG. 12(a)

Quantity of second
transmission bits

Zero matrix

LDPC matrix

Identity matrix

LDGM part

FIG. 12(b)

Quantity of second
transmission bits

Zero matrix

LDPC matrix

Identity matrix

LDGM part

## FIG. 12(c)

Quantity of second
transmission bits

Zero matrix

NR LDPC matrix

Identity matrix

LDGM part

Punctured high weight columns

## FIG. 13

Second transmission bits

Informtion bits | Shortened all-zero bits | First check bits | Second check bits

FIG. 14

Quantity of second transmission bits

Quantity of second transmission bits

LDPC matrix | Zero matrix

LDGM part

FIG. 15

Second transmission bits

Second transmission bits

Informtion bits | Shortened all-zero bits | First check bits | Second check bits

FIG. 16

```
┌─────────────────────┐                    ┌──────────────────────┐
│  Sending apparatus  │                    │ Receiving apparatus  │
└─────────────────────┘                    └──────────────────────┘
```

S1000: Obtain information bits and a
quantity of second transmission bits

S1001: Process the information bits based
on the quantity of the second transmission
bits, to obtain the second transmission bits

S1002: Second transmission bits

S10031: Determine a codeword based on
the quantity of the second transmission
bits

S10032: Decode the codeword, to obtain
the information bits

FIG. 17

FIG. 18

FIG. 19

Processing unit 2001 — Storage unit 2003

Receiving unit 2002

Receiving apparatus 200

FIG. 20

2100

Communication device

2104

Communication interface

2101

Processor

2102

2103

Memory

FIG. 21

**EP 4 047 846 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201911194568

- WO 2018144560 A1

**Non-patent literature cited in the description**

- LDPC Code Proposal; 15-10-0242-00-004g-ldpc-code-proposal. **QIN WANG (USTB**. IEEE DRAFT; 15-10-0242-00-004G-LDPC-CODE-PROPOSAL. IEEE-SA MENTOR, vol. 802